(19) Europäisches Patentamt
European Patent Office
Office européen des brevets

(11) **EP 4 245 883 A1**

(12) **EUROPEAN PATENT APPLICATION**

(43) Date of publication:
**20.09.2023 Bulletin 2023/38**

(21) Application number: **23156372.7**

(22) Date of filing: **13.02.2023**

(51) International Patent Classification (IPC):
**C23C 16/04** (2006.01)   **C23C 16/455** (2006.01)
**C23C 16/34** (2006.01)

(52) Cooperative Patent Classification (CPC):
**C23C 16/04; C23C 16/0272; C23C 16/345;
C23C 16/45529; C23C 16/45534; C23C 16/45544;
C23C 16/45553; H01L 21/0228; H01L 21/02296**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.03.2022   JP 2022039581**

(71) Applicant: **Kokusai Electric Corp.
Tokyo 1010045 (JP)**

(72) Inventors:
• **NAKATANI, Kimihiko
Toyama, 9392393 (JP)**
• **HASHIMOTO, Yoshitomo
Toyama, 9392393 (JP)**

(74) Representative: **Bardehle Pagenberg
Partnerschaft mbB
Patentanwälte Rechtsanwälte
Prinzregentenplatz 7
81675 München (DE)**

(54) **METHOD OF PROCESSING SUBSTRATE, METHOD OF MANUFACTURING SEMICONDUCTOR DEVICE, SUBSTRATE PROCESSING APPARATUS, AND PROGRAM**

(57)   There is provided a technique that includes: (a) forming an inhibitor layer on a first surface of a substrate, which includes the first surface and a second surface, by supplying a modifying agent that reacts with the first surface to the substrate; (b) forming a first film on the second surface by supplying a first film-forming agent, at least a portion of which being provided with a first energy, to the substrate in which the inhibitor layer is formed on the first surface; and (c) forming a second film on the first film formed on the second surface by supplying a second film-forming agent, at least a portion of which being provided with a second energy which is higher than the first energy, to the substrate in which the first film is formed on the second surface.

FIG. 4

**Description**

CROSS-REFERENCE TO RELATED APPLICATION

This application is based upon and claims the benefit of priority from Japanese Patent Application No. 2022-039581, filed on March 14, 2022, the entire contents of which are incorporated herein by reference.

TECHNICAL FIELD

The present disclosure relates to a method of processing a substrate, a method of manufacturing a semiconductor device, a substrate processing apparatus, and a program.

BACKGROUND

In the related art, as a process of manufacturing a semiconductor device, a process of selectively growing and forming a film on a specific surface among a plurality of types of surfaces in which materials existing on the surface of a substrate are different (hereinafter, this process is also referred to as selective growth or selective film formation) may be often carried out.

However, the film selectively formed on the specific surface among the plurality of types of surfaces existing on the surface of the substrate by the selective growth may be oxidized by exposure to the atmosphere.

SUMMARY

Some embodiments of the present disclosure provide a technique capable of suppressing oxidation of a film, which is formed by selective growth, due to exposure to the atmosphere.

According to some embodiments of the present disclosure, there is provided a technique that includes: (a) forming an inhibitor layer on a first surface of a substrate, which includes the first surface and a second surface, by supplying a modifying agent that reacts with the first surface to the substrate; (b) forming a first film on the second surface by supplying a first film-forming agent, at least a portion of which being provided with a first energy, to the substrate in which the inhibitor layer is formed on the first surface; and (c) forming a second film on the first film formed on the second surface by supplying a second film-forming agent, at least a portion of which being provided with a second energy which is higher than the first energy, to the substrate in which the first film is formed on the second surface.

BRIEF DESCRIPTION OF DRAWINGS

The accompanying drawings, which are incorporated in and constitute a part of the specification, illustrate embodiments of the present disclosure.

FIG. 1 is a schematic structure view of a vertical process furnace of a substrate processing apparatus suitably used in some embodiments of the present disclosure, in which a portion of the process furnace is shown in a vertical cross section.

FIG. 2 is a schematic structure view of the vertical process furnace of the substrate processing apparatus suitably used in the embodiments of the present disclosure, in which a portion of the process furnace 202 is shown in a cross section taken along line A-A in FIG. 1.

FIG. 3 is a schematic structure diagram of a controller of the substrate processing apparatus suitably used in the embodiments of the present disclosure, in which a control system of the controller is shown in a block diagram.

FIG. 4 is a diagram showing a processing sequence according to the embodiments of the present disclosure.

FIG. 5A is a schematic cross-sectional view showing a wafer surface including a first surface and a second surface.

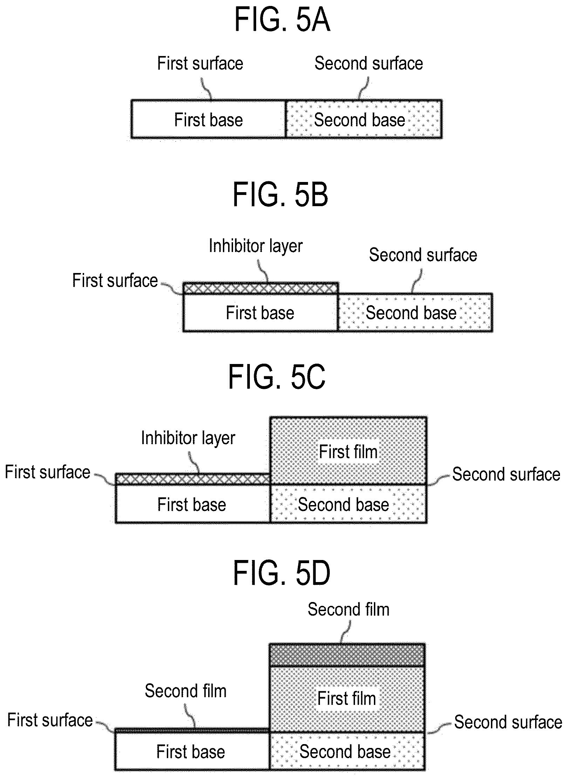

FIG. 5B is a schematic cross-sectional view showing the wafer surface after an inhibitor layer is selectively formed on the first surface by performing a modifying step from a state of FIG. 5A. FIG. 5C is a schematic cross-sectional view showing the wafer surface after a first film is selectively formed on the second surface by performing a first film-forming step from a state of FIG. 5B. FIG. 5D is a schematic cross-sectional view showing the wafer surface after a second film is formed on the first film formed on the second surface by performing a second film-forming step from a state of FIG. 5C and a second film thinner than the second film formed on the first film is formed on the first surface.

FIG. 6 is a graph showing evaluation results in examples, a comparative example, and a reference example.

DETAILED DESCRIPTION

Reference will now be made in detail to various embodiments, examples of which are illustrated in the accompanying drawings. In the following detailed description, numerous specific details are set forth to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

<Embodiments of the Present Disclosure>

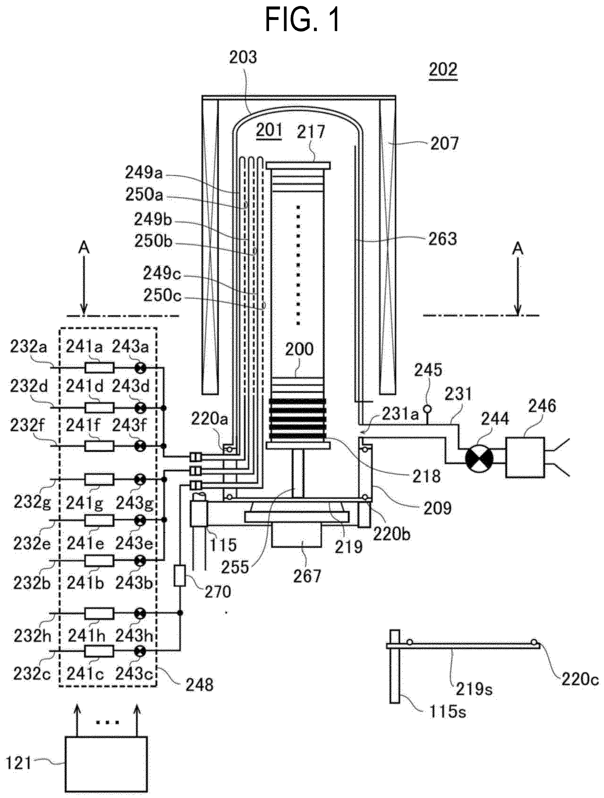

Some embodiments of the present disclosure will now be described mainly with reference to FIGS. 1 to 4 and 5A to 5D. Further, the drawings used in the following description are schematic, and dimensional relationships, ratios, and the like among various components shown in figures may not match actual ones. Further, dimensional relationship, ratios, and the like of various components among plural figures may not match each other.

(1) Structure of Substrate Processing Apparatus

As shown in FIG. 1, a process furnace 202 includes a heater 207 as a temperature regulator (a heating part). The heater 207 is formed in a cylindrical shape and is supported by a support plate to be vertically installed. The heater 207 functions as an energy supplier that provides an energy to a gas and also functions as an activator (an exciter) when the gas is thermally activated (excited).

A reaction tube 203 is disposed inside the heater 207 to be concentric with the heater 207. The reaction tube 203 is made of, for example, heat resistant material such as quartz ($SiO_2$) or silicon carbide (SiC), and is formed in a cylindrical shape with its upper end closed and its lower end opened. A manifold 209 is disposed to be concentric with the reaction tube 203 under the reaction tube 203. The manifold 209 is made of, for example, metal material such as stainless steel (SUS), and is formed in a cylindrical shape with both of its upper and lower ends opened. The upper end of the manifold 209 engages with the lower end of the reaction tube 203 to support the reaction tube 203. An O-ring 220a serving as a seal is provided between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical portion of the process container. The process chamber 201 is configured to be capable of accommodating wafers 200 as substrates. The wafers 200 are processed in the process chamber 201.

Nozzles 249a to 249c as first to third suppliers are respectively installed in the process chamber 201 to penetrate through a sidewall of the manifold 209. The nozzles 249a to 249c are also referred to as first to third nozzles, respectively. The nozzles 249a to 249c are made of, for example, heat resistant material such as quartz or SiC. Gas supply pipes 232a to 232c are connected to the nozzles 249a to 249c, respectively. The nozzles 249a to 249c are different nozzles, and each of the nozzles 249a and 249c is installed adjacent to the nozzle 249b.

Mass flow controllers (MFCs) 241a to 241c, which are flow rate controllers (flow rate control parts), and valves 243a to 243c, which are opening/closing valves, are installed at the gas supply pipes 232a to 232c, respectively, sequentially from the upstream side of a gas flow. Gas supply pipes 232d and 232f are respectively connected to the gas supply pipe 232a at the downstream side of the valves 243a. Gas supply pipes 232e and 232g are respectively connected to the gas supply pipe 232b at the downstream side of the valves 243b. A gas supply pipe 232h is connected to the gas supply pipe 232c at the downstream side of the valves 243c. A remote plasma unit (RPU) 270, which is a plasma exciter (plasma generation part or plasma generator) that excites a gas into a plasma state, is installed at the downstream side of a connecting portion of the gas supply pipe 232c with the gas supply pipe 232h. MFCs 241d to 241h and valves 243d to 243h are installed at the gas supply pipes 232d to 232h, respectively, sequentially from the upstream side of a gas flow. The gas supply pipes 232a to 232h are made of, for example, metal material such as SUS.

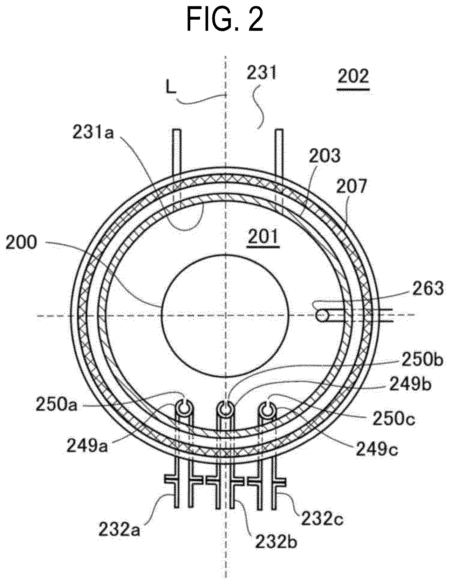

As shown in FIG. 2, the nozzles 249a to 249c are respectively installed in an annular space (in a plane view) between an inner wall of the reaction tube 203 and the wafers 200 to extend upward from a lower side to an upper side of the inner wall of the reaction tube 203, that is, along an arrangement direction of the wafers 200. Specifically, the nozzles 249a to 249c are respectively installed in a region horizontally surrounding a wafer arrangement region in which the wafers 200 are arranged at a lateral side of the wafer arrangement region, along the wafer arrangement region. In the plane view, the nozzle 249b is disposed to face an exhaust port 231a to be described below in a straight line with centers of the wafers 200, which are loaded into the process chamber 201, interposed therebetween. The nozzles 249a and 249c are arranged to sandwich a straight line L passing through the nozzle 249b and the center of the exhaust port 231a from both sides along the inner wall of the reaction tube 203 (outer peripheral side of the wafers 200). The straight line L is also a straight line passing through the nozzle 249b and the centers of the wafers 200. That is, the nozzle 249c may be installed at the opposite side of the nozzle 249a with the straight line L interposed therebetween. The nozzles 249a and 249c are arranged in line symmetry with the straight line L as an axis of symmetry. Gas supply holes 250a to 250c configured to supply a gas are formed on the side surfaces of the nozzles 249a to 249c, respectively. Each of the gas supply holes 250a to 250c is opened to oppose (face) the exhaust port 231a in the plane view, which enables a gas to be supplied toward the wafers 200. A plurality of gas supply holes 250a to 250c are formed from the lower side to the upper side of the reaction tube 203.

A modifying agent is supplied from the gas supply pipe 232a into the process chamber 201 via the MFC 241a, the valve 243a, and the nozzle 249a.

A first precursor is supplied from the gas supply pipe 232b into the process chamber 201 via the MFC 241b, the valve 243b, and the nozzle 249b. The first precursor is used as a first film-forming agent.

A first reactant and a second reactant are supplied from the gas supply pipe 232c into the process chamber 201 via the MFC 241c, the valve 243c, and the nozzle 249c. The first reactant is used as a first film-forming agent. The second reactant is used as a second film-forming agent.

A second precursor is supplied from the gas supply pipe 232d into the process chamber 201 via the MFC 241d, the valve 243d, the gas supply pipe 232a, and the nozzle 249a. The second precursor is used as a second film-forming agent.

A cleaning agent is supplied from the gas supply pipe 232e into the process chamber 201 via the MFC 241e, the valve 243e, the gas supply pipe 232b, and the nozzle 249b.

An inert gas is supplied from the gas supply pipes 232f to 232h into the process chamber 201 via the MFCs 241f to 241h, the valves 243f to 243h, the gas supply pipes 232a to 232c, and the nozzles 249a to 249c, respectively. The inert gas acts as a purge gas, a carrier gas, a dilution gas, or the like.

A modifying agent supply system mainly includes the gas supply pipe 232a, the MFC 241a, and the valve 243a. A first precursor supply system mainly includes the gas supply pipe 232b, the MFC 241b, and the valve 243b. A first reactant supply system and a second reactant supply system mainly include the gas supply pipe 232c, the MFC 241c, and the valve 243c. A second precursor supply system mainly includes the gas supply pipe 232d, the MFC 241d, and the valve 243d. A cleaning agent supply system mainly includes the gas supply pipe 232e, the MFC 241e, and the valve 243e. An inert gas supply system mainly includes the gas supply pipes 232f to 232h, the MFCs 241f to 241h, and the valves 243f to 243h. Each or the entirety of the first precursor supply system and the first reactant supply system is also referred to as a first film-forming agent supply system. Each or the entirety of the second precursor supply system and the second reactant supply system is also referred to as a second film-forming agent supply system.

One or the entirety of the above-described various supply systems may be constituted as an integrated supply system 248 in which the valves 243a to 243h, the MFCs 241a to 241h, and so on are integrated. The integrated supply system 248 is connected to each of the gas supply pipes 232a to 232h, and is configured such that an operation of supplying various materials (various gases) into the gas supply pipes 232a to 232h (that is, an opening/closing operation of the valves 243a to 243h, a flow rate regulation operation by the MFCs 241a to 241h, and the like) are controlled by a controller 121 to be described below. The integrated supply system 248 is constituted as an integral type or division type integrated unit, and may be attached to or detached from the gas supply pipes 232a to 232h and the like on an integrated unit basis, such that maintenance, replacement, extension, and the like of the integrated supply system 248 may be performed on an integrated unit basis.

The exhaust port 231a configured to exhaust an internal atmosphere of the process chamber 201 is provided at the lower side of the sidewall of the reaction tube 203. As shown in FIG. 2, the exhaust port 231a is provided at a position opposing (facing) the nozzles 249a to 249c (the gas supply holes 250a to 250c) with the wafers 200 interposed therebetween in the plane view. The exhaust port 231a may be provided to extend from the lower side to the upper side of the sidewall of the reaction tube 203, that is, along the wafer arrangement region. An exhaust pipe 231 is connected to the exhaust port 231a. A vacuum pump 246 as a vacuum exhauster is connected to the exhaust pipe 231 via a pressure sensor 245, which is a pressure detector (pressure detection part) configured to detect an internal pressure of the process chamber 201, and an auto pressure controller (APC) valve 244, which is a pressure regulator (pressure regulation part). The APC valve 244 is configured to be capable of performing or stopping vacuum exhausting operation of the inside of the process chamber 201 by being opened/closed while the vacuum pump 246 is actuated, and is also configured to be capable of regulating the internal pressure of the process chamber 201 by adjusting an opening state of the valve based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219 as a furnace opening lid configured to be capable of airtightly closing a lower end opening of the manifold 209 is installed below the manifold 209. The seal cap 219 is made of, for example, metal material such as SUS, and is formed in a disc shape. An O-ring 220b as a seal, which comes into contact with the lower end of the manifold 209, is installed on an upper surface of the seal cap 219. A rotator 267 configured to rotate a boat 217 to be described below is installed below the seal cap 219. A rotary shaft 255 of the rotator 267 is connected to the boat 217 through the seal cap 219. The rotator 267 is configured to rotate the wafers 200 by rotating the boat 217. The seal cap 219 is configured to be vertically moved up or down by a boat elevator 115 which is an elevator installed outside the reaction tube 203. The boat elevator 115 is constituted as a transfer apparatus (transfer mechanism) which loads/unloads (transfers) the wafers 200 into/out of the process chamber 201 by moving the seal cap 219 up or down.

Below the manifold 209, a shutter 219s is installed as a furnace opening lid configured to be capable of airtightly closing the lower end opening of the manifold 209 while the seal cap 219 is lowered and the boat 217 is unloaded from the process chamber 201. The shutter 219s is made of, for example, metal material such as SUS, and is formed in a disc shape. An O-ring 220c as a seal, which comes into contact with the lower end of the manifold 209, is installed on an upper surface of the shutter 219s. The opening/closing operation (such as elevation operation, rotation operation, or the like) of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, heat resistant material such as quartz or SiC. Heat insulating plates 218 made of, for example, heat resistant material such as quartz or SiC are installed in multiple stages at the bottom the boat 217.

A temperature sensor 263 serving as a temperature detector is installed in the reaction tube 203. Based on temperature information detected by the temperature sensor 263, a state of supplying electric power to the heater 207 is regulated such that a temperature distribution in the process chamber 201 becomes a desired temperature distribution. The temperature sensor 263 is installed along the inner wall of the reaction tube 203.

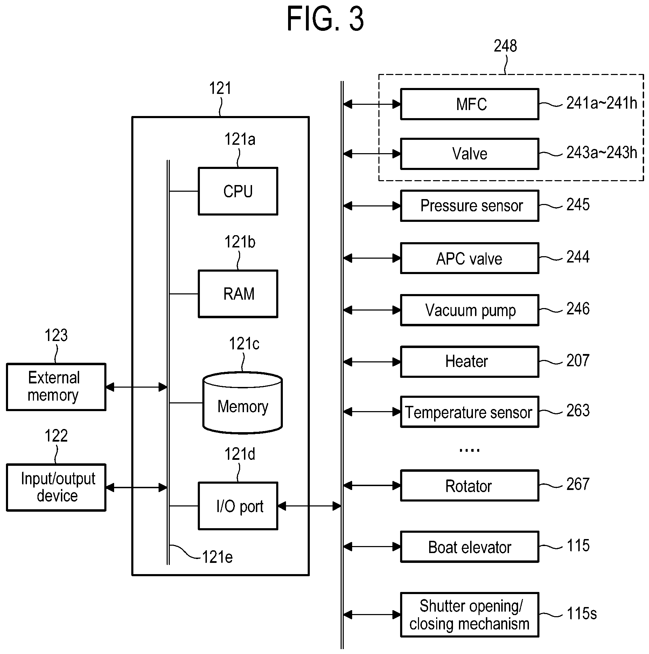

As shown in FIG. 3, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 including, e.g., a touch panel or the like, is connected to the controller 121. Further, an external memory 123 may be connected to the controller 121.

The memory 121c includes, for example, a flash memory, a hard disk drive (HDD), a solid state drive (SSD), or the like. A control program that controls operations of a substrate processing apparatus, a process recipe in which sequences and conditions of substrate processing to be described below are written, and the like are readably stored in the memory 121c. The process recipe functions as a program that causes, by the controller 121, the substrate processing apparatus to perform each sequence in the substrate processing to be described below to obtain an expected result. Hereinafter, the process recipe and the control program may be generally and simply referred to as a "program." Further, the process recipe may be simply referred to as a "recipe." When the term "program" is used herein, it may indicate a case of including the recipe, a case of including the control program, or a case of including both the recipe and the control program. The RAM 121b is configured as a memory area (work area) in which programs or data read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opening/closing mechanism 115s, and so on.

The CPU 121a is configured to be capable of reading and executing the control program from the memory 121c. The CPU 121a is also configured to be capable of reading the recipe from the memory 121c according to an input of an operation command from the input/output device 122, or the like. The CPU 121a is configured to be capable of controlling the flow rate regulating operation of various kinds of materials (gases) by the MFCs 241a to 241h, the opening/closing operation of the valves 243a to 243h, the opening/closing operation of the APC valve 244, the pressure regulating operation performed by the APC valve 244 based on the pressure sensor 245, the actuating and stopping operation of the vacuum pump 246, the temperature regulating operation performed by the heater 207 based on the temperature sensor 263, the operation of rotating the boat 217 and adjusting the rotation speed of the boat 217 with the rotator 267, the operation of moving the boat 217 up or down by the boat elevator 115, the opening/closing operation of the shutter 219s by the shutter opening/closing mechanism 115s, and so on, according to contents of the read recipe.

The controller 121 may be constituted by installing, in the computer, the aforementioned program stored in the external memory 123. Examples of the external memory 123 may include a magnetic disc such as a HDD, an optical disc such as a CD, a magneto-optical disc such as a MO, a semiconductor memory such as a USB memory or a SSD, and the like. The memory 121c or the external memory 123 is constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. Furthermore, the program may be provided to the computer by using communication means or unit such as the Internet or a dedicated line, instead of using the external memory 123.

5

(2) Substrate Processing Process

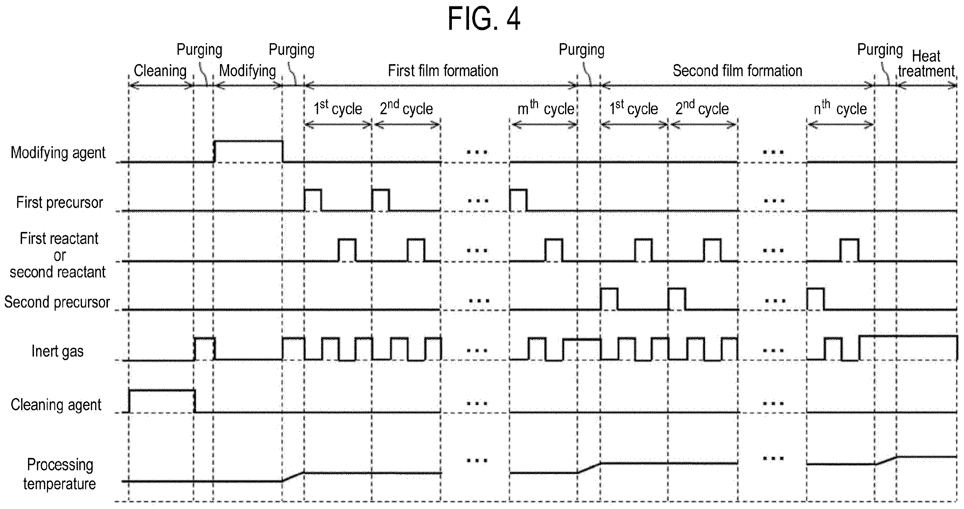

As a process of manufacturing a semiconductor device by using the above-described substrate processing apparatus, an example of a method of processing a substrate, that is, a processing sequence of selectively laminating a first film and a second film on a second surface of a wafer 200 as a substrate among a first surface and the second surface of the wafer 200, will be described mainly with reference to FIGS. 4 and 5A to 5D. In the following descriptions, operations of the respective components constituting the substrate processing apparatus are controlled by the controller 121.

The surface of the wafer 200 includes a first base and a second base, a surface of the first base constitutes a first surface, and a surface of the second base constitutes a second surface. In the following description, for the sake of convenience, as a typical example, a case where the first base is a silicon oxide film ($SiO_2$ film, hereinafter also referred to as a SiO film) as an oxide film (oxygen-containing film) and the second base is a silicon nitride film ($Si_3N_4$ film, hereinafter also referred to as a SiN film) as a non-oxide film (oxygen-free film) will be described. That is, hereinafter, a case where the first surface includes the surface of the SiO film as the first base and the second surface includes the surface of the SiN film as the second base will be described. The first base and the second base are also referred to as a first base film and a second base film, respectively.

A processing sequence in the embodiments of the present disclosure includes:

(a) a step of forming an inhibitor layer on a first surface of a wafer 200 as a substrate including the first surface and a second surface by supplying a modifying agent that reacts with the first surface to the substrate (modifying step);
(b) a step of forming a first film on the second surface by supplying a first film-forming agent, at least a portion of which being provided with a first energy, to the wafer 200 in which the inhibitor layer is formed on the first surface (first film-forming step); and
(c) a step of forming a second film on the first film formed on the second surface by supplying a second film-forming agent, at least a portion of which being provided with a second energy which is higher than the first energy, to the wafer 200 in which the first film is formed on the second surface (second film-forming step).

In the following example, a case of using a first precursor and a first reactant as the first film-forming agent will be described. In this case, the first film-forming agent, at least a portion of which being provided with the first energy, means that at least one selected from the group of the first precursor and the first reactant is provided with the first energy. In this case, at least one selected from the group of the first precursor and the first reactant may be excited by the first energy. Further, in the following example, a case where a second precursor and a second reactant are used as the second film-forming agent will be described. In this case, the second film-forming agent, at least a portion of which being provided with the second energy higher than the first energy, means that at least one selected from the group of the second precursor and the second reactant is provided with the second energy higher than the first energy. In this case, at least one selected from the group of the second precursor and the second reactant may be excited by the second energy.

Further, in the following example, a case of alternately supplying the first precursor and the first reactant as the first film-forming agent to the wafer 200 in the first film-forming step and alternately supplying the second precursor and the second reactant as the second film-forming agent to the wafer 200 in the second film-forming step will be described. Specifically, as shown in FIG. 4, a case of alternately performing a step of supplying the first precursor to the wafer 200 and a step of supplying the first reactant to the wafer 200 in the first film-forming step and alternately performing a step of supplying the second precursor to the wafer 200 and a step of supplying the second reactant to the wafer 200 in the second film-forming step will be described.

That is, for example, a processing sequence shown in FIG. 4 includes performing:

(a) a modifying step of forming an inhibitor layer on a first surface of a wafer 200 including the first surface and a second surface by supplying a modifying agent that reacts with the first surface to the wafer 200;
(b) a first film-forming step of forming a first film on the second surface by performing a cycle a predetermined number of times (m times, where m is an integer of 1 or more), the cycle including performing a step of supplying a first precursor to the wafer 200 (first precursor supply step) and a step of supplying a first reactant to the wafer 200 (first reactant supply step); and
(c) a second film-forming step of forming a second film on the first film formed on the second surface by performing a cycle a predetermined number of times (n times, where n is an integer of 1 or more), the cycle including performing a step of supplying a second precursor to the wafer 200 (second precursor supply step) and a step of supplying a second reactant to the wafer 200 (second reactant supply step).

Further, in the following example, as shown in FIG. 4, a case of setting a processing temperature in the second film-forming step (hereinafter also referred to as a second temperature) to be higher than a processing temperature in the first film-forming step (hereinafter also referred to as a first temperature) will be described. By controlling the processing temperature as in this case, in the second film-forming step, the second energy higher than the first energy provided to the first precursor and the first reactant is provided to the second precursor and the second reactant. In this case, by heating the first precursor and the first reactant at the first temperature, the first energy is provided to the first precursor and the first reactant, and by heating the second precursor and the second reactant at the second temperature, the second energy is provided to the second precursor and the second reactant.

In the present disclosure, for the sake of convenience, the above-described processing sequence may be denoted as follows. The same denotation may be used in modifications and other embodiments to be described below.

$$\text{Modifying agent} \rightarrow (\text{First precursor} \rightarrow \text{First reactant}) \times m \rightarrow (\text{Second precursor} \rightarrow \text{Second reactant}) \times n$$

Further, as in the processing sequence shown below, a cleaning step of removing a native oxide film formed on the surface of the wafer 200 by supplying a cleaning agent to the wafer 200 may be further performed before performing the modifying step. Further, as in the processing sequence shown below, a heat treating step of heat-treating the wafer 200 may be further performed after performing the second film-forming step. Further, both the cleaning step and the heat treating step may be performed as in the processing sequence shown in FIG. 4 and below.

$$\text{Cleaning agent} \rightarrow \text{Modifying agent} \rightarrow (\text{First precursor} \rightarrow \text{First reactant}) \times m \rightarrow (\text{Second precursor} \rightarrow \text{Second reactant}) \times n$$

$$\text{Modifying agent} \rightarrow (\text{First precursor} \rightarrow \text{First reactant}) \times m \rightarrow (\text{Second precursor} \rightarrow \text{Second reactant}) \times n \rightarrow \text{Heat treatment}$$

$$\text{Cleaning agent} \rightarrow \text{Modifying agent} \rightarrow (\text{First precursor} \rightarrow \text{First reactant}) \times m \rightarrow (\text{Second precursor} \rightarrow \text{Second reactant}) \times n \rightarrow \text{Heat treatment}$$

When the term "wafer" is used in the present disclosure, it may refer to "a wafer itself" or " a stacked body of a wafer and certain layers or films formed on a surface of the wafer." When the phrase "a surface of a wafer" is used in the present disclosure, it may refer to "a surface of a wafer itself" or "a surface of a certain layer formed on a wafer." When the expression "a certain layer is formed on a wafer" is used in the present disclosure, it may mean that "a certain layer is formed directly on a surface of a wafer itself" or that "a certain layer is formed on a layer formed on a wafer." When the term "substrate" is used in the present disclosure, it may be synonymous with the term "wafer."

The term "agent" used in the present disclosure includes at least one selected from the group of gaseous substance and liquefied substance. The liquefied substance includes misty substance. That is, each of the modifying agent, the first film-forming agent (the first precursor and the first reactant), and the second film-forming agent (the second precursor and the second reactant) may include gaseous substance, liquefied substance such as misty substance, or both of them.

The term "layer" used in the present disclosure includes at least one selected from the group of a continuous layer and a discontinuous layer. For example, the inhibitor layer may include a continuous layer, a discontinuous layer, or both of them as long as it may cause a film formation inhibition action.

(Wafer Charging and Boat Loading)

After the boat 217 is charged with a plurality of wafers 200 (wafer charging), the shutter 219s is moved by the shutter opening/closing mechanism 115s and the lower end opening of the manifold 209 is opened (shutter opening). Thereafter, as shown in FIG. 1, the boat 217 supporting the plurality of wafers 200 is lifted by the boat elevator 115 and loaded into the process chamber 201 (boat loading). In this state, the seal cap 219 seals the lower end of the manifold 209 via the O-ring 220b. Thus, the wafers 200 are provided inside the process chamber 201.

Each wafer 200 charged in the boat 217 includes a first surface and a second surface, as shown in FIG. 5A. The first surface is a surface of the first base and the second surface is a surface of the second base. As described above, for example, a case where the first surface is a surface of a SiO film as the first base and the second surface is a surface of a SiN film as the second base will be described.

(Pressure Regulation and Temperature Regulation)

After the boat loading is completed, the inside of the process chamber 201, that is, a space where the wafers 200 are placed, is vacuum-exhausted (decompression-exhausted) by the vacuum pump 246 to reach a desired pressure (state of vacuum). In this operation, the internal pressure of the process chamber 201 is measured by the pressure sensor 245, and the APC valve 244 is feedback-controlled based on the measured pressure information. Further, the wafers 200 in the process chamber 201 are heated by the heater 207 to reach a desired processing temperature. In this operation, a state of supplying electric power to the heater 207 is feedback-controlled based on the temperature information detected by the temperature sensor 263 such that a temperature distribution in the process chamber 201 becomes a desired temperature distribution. Further, the rotation of the wafers 200 by the rotator 267 is started. The exhaust of the inside of the process chamber 201 and the heating and rotation of the wafers 200 may be continuously performed at least until the processing on the wafers 200 is completed.

(Cleaning Step)

After that, a cleaning agent is supplied to the wafer 200.
Specifically, the valve 243e is opened to allow the cleaning agent to flow through the gas supply pipe 232e. A flow rate of the cleaning agent is regulated by the MFC 241e, and the cleaning agent is supplied into the process chamber 201 via the gas supply pipe 232b and the nozzle 249b and is exhausted via the exhaust port 231a. In this operation, the cleaning agent is supplied to the wafer 200 from the side of the wafer 200 (cleaning agent supply). At this time, the valves 243f to 243h may be opened to allow an inert gas to be supplied into the process chamber 201 via the nozzles 249a to 249c, respectively.
By supplying the cleaning agent to the wafer 200 under a processing condition to be described below, a native oxide film formed on the second surface of the wafer 200 may be removed (etched) to expose the second surface. In this operation, the surface of the first base and the surface of the second base of the wafer 200, that is, the first surface and the second surface, are exposed as shown in FIG. 5A. In a case where the first base is a SiO film and the second base is a SiN film, when the first surface and the second surface are exposed, the first surface is OH-terminated over the entire region thereof, and many regions of the second surface are not OH-terminated. That is, the first surface is terminated with OH groups over the entire region, and many regions of the second surface are not terminated with OH groups.
A processing condition when supplying the cleaning agent in the cleaning step is exemplified as follows.

Processing temperature: 50 to 200 degrees C, specifically 70 to 150 degrees C,
Processing pressure: 10 to 2,000 Pa, specifically 100 to 1,500 Pa,
Processing time: 10 to 60 minutes, specifically 30 to 60 minutes,
Cleaning agent supply flow rate: 0.05 to 1 slm, specifically 0.1 to 0.5 slm, and
Inert gas supply flow rate (for each gas supply pipe): 1 to 10slm, specifically 2 to 10 slm.

In the present disclosure, notation of a numerical range such as "50 to 200 degrees C" means that a lower limit value and an upper limit value are included in the range. Therefore, for example, "50 to 200 degrees C" means "50 degrees C or higher and 200 degrees C or lower." The same applies to other numerical ranges. In the present disclosure, the processing temperature means the temperature of the wafer 200 or the internal temperature of the process chamber 201, and the processing pressure means the internal pressure of the process chamber 201. Further, the processing time means a time during which a process is continued. Further, when 0 slm is included in the supply flow rate, 0 slm means a case where no substance (gas) is supplied. The same applies to the following description.
After removing the native oxide film from the second surface to expose the second surface, the valve 243e is closed to stop the supply of the cleaning agent into the process chamber 201. Then, the inside of the process chamber 201 is vacuum-exhausted to remove gaseous substance and the like remaining in the process chamber 201 from the inside of the process chamber 201. At this time, the valves 243f to 243h are opened to allow an inert gas to be supplied into the process chamber 201 via the nozzles 249a to 249c. The inert gas supplied from the nozzles 249a to 249c acts as a purge gas, whereby the inside of the process chamber 201 is purged (purging).
A processing condition when the purging is performed in the cleaning step is exemplified as follows.

Processing pressure: 1 to 30 Pa,
Processing time: 1 to 120 seconds, specifically 1 to 60 seconds, and
Inert gas supply flow rate (for each gas supply pipe): 0.5 to 20 slm.

Further, the processing temperature when the purging is performed in this step may be the same as the processing temperature when supplying the cleaning agent.

As the cleaning agent, for example, a fluorine (F)-containing gas may be used. As the F-containing gas, for example, a chlorine trifluoride (ClF$_3$) gas, a chlorine fluoride (ClF) gas, a nitrogen fluoride (NF$_3$) gas, a hydrogen fluoride (HF) gas, a fluorine (F$_2$) gas, or the like may be used. Various cleaning liquids may also be used as the cleaning agent. For example, DHF cleaning may be performed by using a HF aqueous solution as the cleaning agent. Further, for example, SC-1 cleaning (APM cleaning) may be performed by using a cleaning liquid containing ammonia water, hydrogen peroxide water, and pure water as the cleaning agent. Further, for example, SC-2 cleaning (HPM cleaning) may be performed by using cleaning liquid containing hydrochloric acid, hydrogen peroxide water, and pure water as the cleaning agent. Further, for example, SPM cleaning may be performed by using a cleaning liquid containing sulfuric acid and hydrogen peroxide water as the cleaning agent. That is, the cleaning agent may be gaseous substance or liquid substance. Further, the cleaning agent may be liquid substance such as misty substance. One or more selected from the group of these substances may be used as the cleaning agent.

As the inert gas, a rare gas such as a nitrogen (N$_2$) gas, an argon (Ar) gas, a helium (He) gas, a neon (Ne) gas, and a xenon (Xe) gas may be used. One or more selected from the group of these gases may be used as the inert gas. The same applies to each step to be described below.

In the case of using the wafer 200 from which the native oxide film formed on the surface of the wafer 200 is removed in advance, the cleaning step may be omitted. In that case, a modifying step to be described below may be performed after the pressure regulation and temperature regulation.

(Modifying Step)

After performing the cleaning step, a modifying agent, which reacts with the first surface, is supplied to the wafer 200.

Specifically, the valve 243a is opened to allow the modifying agent to flow through the gas supply pipe 232a. A flow rate of the modifying agent is regulated by the MFC 241a, and the modifying agent is supplied into the process chamber 201 via the nozzle 249a and is exhausted via the exhaust port 231a. In this operation, the modifying agent is supplied to the wafer 200 from the lateral side of the wafer 200 (modifying agent supply). At this time, the valves 243f to 243h may be opened to allow an inert gas to be supplied into the process chamber 201 via the nozzles 249a to 249c, respectively.

By supplying the modifying agent, which reacts with the first surface, to the wafer 200 under a processing condition to be described below, inhibitor molecules, which are at least a portion of the molecular structure of molecules constituting the modifying agent may be chemisorbed on the first surface of the wafer 200 to form an inhibitor layer on the first surface, as shown in FIG. 5B. That is, in this step, by supplying the modifying agent, which reacts with the first surface, to the wafer 200, the inhibitor molecules contained in the modifying agent may be adsorbed on the first surface to form the inhibitor layer on the first surface. In other words, in this step, the first surface may be modified to form the inhibitor layer on the first surface. This makes it possible to terminate the first surface, which is the outermost surface of the first base, with the inhibitor molecules that are at least a portion of the molecular structure of the molecules that constitute the modifying agent. The inhibitor molecules are also referred to as film formation inhibition molecules (adsorption inhibition molecules or reaction inhibition molecules). In addition, the inhibitor layer is also referred to as a film formation inhibition layer (adsorption inhibition layer or a reaction inhibition layer).

The inhibitor layer formed in this step contains at least a portion of the molecular structure of the molecules constituting the modifying agent, which are residues derived from the modifying agent. The inhibitor layer prevents adsorption of the first precursor (first film-forming agent) on the first surface to inhibit (suppress) progress of the film-forming reaction on the first surface in a first film-forming step to be described below.

As at least the portion of the molecular structure of the molecules constituting the modifying agent, that is, the inhibitor molecules may be, for example, a trialkylsilyl group such as a trimethylsilyl group (-SiMe$_3$) or a triethylsilyl group (-SiEt$_3$). The trialkylsilyl group contains an alkyl group which is a type of hydrocarbon group. In these cases, Si of the trimethylsilyl group or the triethylsilyl group is adsorbed on an adsorption site on the first surface of the wafer 200. When the first surface is a surface of a SiO film, the first surface contains an OH termination (OH group) as the adsorption site, and Si of the trimethylsilyl group or the triethylsilyl group is bonded to O of the OH termination (OH group) on the first surface, such that the first surface is terminated with an alkyl group such as a methyl group or an ethyl group. A hydrocarbon group typified by an alkyl group (alkylsilyl group) such as a methyl group (trimethylsilyl group) or an ethyl group (triethylsilyl group), which terminates the first surface, constitutes the inhibitor layer, which prevents adsorption of the precursor (film-forming agent) on the first surface to inhibit (suppress) progress of the film-forming reaction on the first surface in a film-forming step to be described below.

When the inhibitor molecule adsorbed on the adsorption site on the first surface is a trialkylsilyl group such as a trimethylsilyl group (-SiMe$_3$) or a triethylsilyl group (-SiEt$_3$), the inhibitor molecule contains an alkyl group (alkylsilyl group) and the inhibitor layer contains an alkyl group (alkylsilyl group) termination. In the case of an example in which the inhibitor layer contains a hydrocarbon group termination such as an alkyl group (alkylsilyl group) termination, a high film formation inhibition effect is obtained. The alkyl group (alkylsilyl group) termination and the hydrocarbon group termination are also referred to as an alkyl (alkylsilyl) termination and a hydrocarbon termination, respectively.

Further, in this step, at least the portion of the molecular structure of the molecules constituting the modifying agent may be adsorbed on a portion of the second surface of the wafer 200, but an amount of the adsorption is very small and an amount of the adsorption on the first surface of the wafer 200 is overwhelmingly large. Such selective (preferential) adsorption is possible because a processing condition in this step is set such that the modifying agent does not undergo gas-phase decomposition in the process chamber 201. Further, this is also possible because the first surface is OH-terminated over the entire region, whereas many regions on the second surface are not OH-terminated. In this step, since the modifying agent does not undergo the gas-phase decomposition in the process chamber 201, at least a portion of the molecular structure of the molecules constituting the modifying agent is not multiple-deposited on the first surface and the second surface, and at least a portion of the molecular structure of the molecules constituting the modifying agent is selectively adsorbed on the first surface among the first surface and the second surface, whereby the first surface is selectively terminated by at least the portion of the molecular structure of the molecules constituting the modifying agent.

A processing condition when supplying the modifying agent in the modifying step is exemplified as follows.

Processing temperature: room temperature (25 degrees C) to 500 degrees C, specifically room temperature to 250 degrees C,
Processing pressure: 5 to 2,000 Pa, specifically 10 to 1,000 Pa,
Modifying agent supply flow rate: 0.001 to 3 slm, specifically 0.001 to 0.5 slm,
Modifying agent supply time: 1 second to 120 minutes, specifically 30 seconds to 60 minutes, and
Inert gas supply flow rate (for each gas supply pipe): 0 to 20 slm.

After selectively forming the inhibitor layer on the first surface of the wafer 200, the valve 243a is closed to stop the supply of the modifying agent into the process chamber 201. Then, a gaseous substance and the like remaining in the process chamber 201 are removed from the process chamber 201 according to the same processing procedure and processing condition as in the purging in the cleaning step (purging). The processing temperature when performing the purging in this step may be the same as the processing temperature when supplying the modifying agent.

As the modifying agent, for example, a compound containing a structure in which an amino group is directly bonded to silicon (Si) or a compound containing a structure in which an amino group and an alkyl group are directly bonded to silicon (Si) may be used.

Examples of the modifying agent may include (dimethylamino)trimethylsilane ($(CH_3)_2NSi(CH_3)_3$, abbreviation: DMATMS), (diethylamino)triethylsilane ($(C_2H_5)_2NSi(C_2H_5)_3$, abbreviation: DEATES), (dimethylamino)triethylsilane ($(CH_3)_2NSi(C_2H_5)_3$, abbreviation: DMATES), (diethylamino)trimethylsilane ($(C_2H_5)_2NSi(CH_3)_3$, abbreviation: DEATMS), (dipropylamino)trimethylsilane ($(C_3H_7)_2NSi(CH_3)_3$, abbreviation: DPATMS), (dibutylamino)trimethylsilane ($(C_4H_9)_2NSi(CH_3)_3$, abbreviation: DBATMS), (trimethylsilyl)amine ($(CH_3)_3SiNH_2$, abbreviation: TMSA), (triethylsilyl)amine ($(C_2H_5)_3SiNH_2$, abbreviation: TESA), (dimethylamino)silane ($(CH_3)_2NSiH_3$, abbreviation: DMAS), (diethylamino)silane ($(C_2H_5)_2NSiH_3$, abbreviation: DEAS), (dipropylamino)silane ($(C_3H_7)_2NSiH_3$, abbreviation: DPAS), (dibutylamino)silane ($(C_4H_9)_2NSiH_3$, abbreviation: DBAS), and the like. One or more selected from the group of these substances may be used as the modifying agent.

Further, examples of the modifying agents may include bis(dimethylamino)dimethylsilane ($[(CH_3)_2N]_2Si(CH_3)_2$, abbreviation: BDMADMS), bis(diethylamino)diethylsilane ($[(C_2H_5)_2N]_2Si(C_2H_5)_2$, abbreviation: BDEADES), bis(dimethylamino)diethylsilane ($[(CH_3)_2N]_2Si(C_2H_5)_2$, abbreviation: BDMADES), bis(diethylamino)dimethylsilane ($[(C_2H_5)_2N]_2Si(CH_3)_2$, abbreviation: BDEADMS), bis(dimethylamino)silane ($[(CH_3)_2N]_2SiH_2$, abbreviation: BDMAS), bis(diethylamino)silane ($[(C_2H_5)_2N]_2SiH_2$, abbreviation: BDEAS), bis(dimethylaminodimethylsilyl)ethane ($[(CH_3)_2N(CH_3)_2Si]_2C_2H_6$, abbreviation: BDMADMSE), bis(dipropylamino)silane ($[(C_3H_7)_2N]_2SiH_2$, abbreviation: BDPAS), bis(dibutylamino)silane ($[(C_4H_9)_2N]_2SiH_2$, abbreviation: BDBAS), bis(dipropylamino)dimethylsilane ($[(C_3H_7)_2N]_2Si(CH_3)_2$, abbreviation: BDPADMS), bis(dipropylamino)diethylsilane ($(C_3H_7)_2N]_2Si(C_2H_5)_2$, abbreviation: BDPADES), (dimethylsilyl)diamine ($(CH_3)_2Si(NH_2)_2$, abbreviation: DMSDA), (diethylsilyl)diamine ($(C_2H_5)_2Si(NH_2)_2$, abbreviation: DESDA), (dipropylsilyl)diamine ($(C_3H_7)_2Si(NH_2)_2$, abbreviation: DPSDA), bis(dimethylaminodimethylsilyl)methane ($[(CH_3)_2N(CH_3)_2Si]_2CH_2$, abbreviation: BDMADMSM), bis(dimethylamino)tetramethyldisilane ($[(CH_3)_2N]_2(CH_3)_4Si_2$, abbreviation: BDMATMDS), and the like. One or more selected from the group of these substances may be used as the modifying agent.

(First Film-Forming Step)

After performing the modifying step, a first film-forming agent, at least a portion of which being provided with a first energy, is supplied to the wafer 200 to form a first film on the second surface of the wafer 200. That is, the first film-forming agent, at least a portion of which being provided with the first energy, is supplied to the wafer 200 so as to react with the second surface to selectively (preferentially) form a film on the second surface. Specifically, the following first precursor supply step and first reactant supply step are sequentially executed. In the following example, a first precursor and a first reactant are each supplied at a first temperature. That is, in the following example, each of the first precursor and the first reactant is heated at the first temperature, thereby providing the first energy to each of the first precursor and the first reactant. In this case, at least one selected from the group of the first precursor and the first reactant may be excited (thermally excited) by the first energy. In addition, in the following example, the first temperature is set to a temperature lower than a second temperature to be described below. In the first precursor supply step and the first reactant supply step, an output of the heater 207 is regulated to keep a processing temperature, that is, the first temperature, equal to or higher than the processing temperature in the modifying step, specifically, as shown in FIG. 4, keep the first temperature higher than the processing temperature in the modifying step.

[First Precursor Supply Step]

In this step, a first precursor (first precursor gas) as a first film-forming agent is supplied to the wafer 200 subjected to the modifying step, that is, the wafer 200 with the inhibitor layer selectively formed on the first surface, at the first temperature.

Specifically, the valve 243b is opened to allow the first precursor to flow through the gas supply pipe 232b. A flow rate of the first precursor is regulated by the MFC 241b, and the first precursor is supplied into the process chamber 201 via the nozzle 249b and is exhausted via the exhaust port 231a. In this operation, the first precursor is supplied to the wafer 200 from a lateral side of the wafer 200 (first precursor supply). At this time, the valves 243f to 243h may be opened to supply an inert gas into the process chamber 201 via the nozzles 249a to 249c, respectively.

By supplying the first precursor to the wafer 200 under a processing condition to be described below, at least a portion of the molecular structure of molecules constituting the first precursor may be selectively chemisorbed on the second surface while suppressing chemisorption of at least a portion of the molecular structure of the molecules constituting the first precursor on the first surface. Thus, a first layer is selectively formed on the second surface. The first layer contains at least a portion of the molecular structure of the molecules constituting the first precursor, which are residues of the first precursor. That is, the first layer contains at least a portion of atoms constituting the first precursor.

In this step, the formation of the first layer may be performed under a low temperature condition as described below, that is, at the first temperature. By forming the first layer at the first temperature in this way, the molecules and atoms constituting the inhibitor layer formed on the first surface may be maintained without being extinguished (desorbed) from the first surface.

Further, by forming the first layer under the low temperature condition as described below, that is, at the first temperature, the first precursor may be prevented from being thermally decomposed (gas-phase decomposed), that is, autolyzed, in the process chamber 201. As a result, multiple deposition of at least a portion of the molecular structure of the molecules constituting the first precursor on the first surface and the second surface may be suppressed, and at least a portion of the molecular structure of the molecules constituting the first precursor may be selectively adsorbed on the second surface among the first surface and the second surface.

Further, in this step, at least a portion of the molecular structure of the molecules constituting the first precursor may be adsorbed on a portion of the first surface of the wafer 200, but an amount of the adsorption on the portion of the first surface is very small and an amount of the adsorption on the second surface of the wafer 200 is overwhelmingly large. Such selective (preferential) adsorption is possible because the processing condition in this step is set to the low temperature condition as described below, that is, a condition in which the precursor does not undergo vapor-phase decomposition in the process chamber 201 at the first temperature. Further, this is also possible because the inhibitor layer is formed over the entire region of the first surface, whereas the inhibitor layer is not formed over many regions of the second surface.

A processing condition when supplying the first precursor in the first precursor supply step is exemplified as follows.

Processing temperature (first temperature): 350 to 600 degrees C, specifically 400 to 550 degrees C,
Processing pressure: 1 to 2,000 Pa, specifically 10 to 1,333 Pa,
First precursor supply flow rate: 0.001 to 2 slm, specifically 0.01 to 1 slm,

First precursor supply time: 1 second to 180 seconds, specifically 10 seconds to 120 seconds, and
Inert gas supply flow rate (for each gas supply pipe): 0 to 20 slm.

After selectively forming the first layer on the second surface of the wafer 200, the valve 243b is closed to stop the supply of the first precursor into the process chamber 201. Then, gaseous substance and the like remaining in the process chamber 201 are removed from the process chamber 201 according to the same processing procedure and processing conditions as the purging in the cleaning step (purging). The processing temperature when the purging is performed in this step may be the same as the processing temperature when supplying the first precursor.

As the first precursor, for example, when forming the first film containing atoms X in the first film-forming step, a gas (substance) containing one or more atoms X in one molecule may be used. Further, a gas (substance) containing no chemical bond between atoms X may be used as the first precursor. The atoms X include Si, germanium (Ge), titanium (Ti), tantalum (Ta), tungsten (W), aluminum (Al), and the like. Specifically, as the first precursor, for example, a Si-containing gas (Si-containing substance) containing one or more Si's in one molecule may be used, or more specifically, a Si-containing gas (Si-containing substance) containing one Si in one molecule may be used. Further, for example, a Si-containing gas (Si-containing substance) that does not contain a chemical bond between Si's, that is, does not contain a Si-Si bond may be used as the first precursor.

As the first precursor, for example, a Si- and halogen-containing gas (Si- and halogen-containing substance) may be used. Halogen includes chlorine (Cl), fluorine (F), bromine (Br), iodine (I), and the like. The Si- and halogen-containing gas may contain halogen in the form of a chemical bond between Si and halogen. As the Si- and halogen-containing gas, for example, a silane-based gas containing a Si-Cl bond, that is, a chlorosilane-based gas, may be used. The Si- and halogen-containing gas may further contain carbon (C), and in this case C may be contained in the form of a Si-C bond. As the Si- and halogen-containing gas, for example, a silane-based gas containing Si, Cl, and, an alkylene group and containing a Si-C bond, that is, an alkylenechlorosilane-based gas, may be used. The alkylene group includes a methylene group, an ethylene group, a propylene group, a butylene group, and the like. Further, as the Si- and halogen-containing gas, for example, a silane-based gas containing Si, Cl, and an alkyl group and containing a Si-C bond, that is, an alkylchlorosilane-based gas, ma be used. The alkyl group includes a methyl group, an ethyl group, a propyl group, a butyl group, and the like. The Si- and halogen-containing gas may further contain O, and in this case, O may be contained in the form of a Si-O bond, for example in the form of a siloxane bond (Si-O-Si bond). As the Si- and halogen-containing gas, for example, a silane-based gas containing Si, Cl, and a siloxane bond, that is, a chlorosiloxane-based gas, may be used. These gases may contain Cl in the form of a Si-Cl bond.

Examples of the first precursor may include bis(trichlorosilyl)methane ($(SiCl_3)_2CH_2$, abbreviation: BTCSM), 1,2-bis(trichlorosilyl)ethane ($(SiCl_3)_2C_2H_4$, abbreviation: BTCSE), 1,1,2,2-tetrachloro-1,2-dimethyldisilane ($(CH_3)_2Si_2Cl_4$, abbreviation: TCDMDS), 1,2-dichloro-1,1,2,2-tetramethyldisilane ($(CH_3)_4Si_2Cl_2$, abbreviation: DCTMDS), 1,1,3,3-tetrachloro-1,3-disilacyclobutane ($C_2H_4Cl_4Si_2$, abbreviation: TCDSCB), and the like. Further, examples of the first precursor may include monochlorosilane ($SiH_3Cl$, abbreviation: MCS), dichlorosilane ($SiH_2Cl_2$, abbreviation: DCS), trichlorosilane ($SiHCl_3$, abbreviation: TCS), tetrachlorosilane ($SiCl_4$, abbreviation: 4CS), hexachlorodisilane ($Si_2Cl_6$, abbreviation: HCDS), octachlorotrisilane ($Si_3Cl_8$, abbreviation: OCTS), and the like. Further, examples of the first precursor may include hexachlorodisiloxane ($Cl_3Si-O-SiCl_3$, abbreviation: HCDSO), octachlorotrisiloxane ($Cl_3Si-O-SiCl_2-O-SiCl_3$, abbreviation: OCTSO), and the like. One or more selected from the group of these substances may be used as the first precursor.

Further, examples of the first precursor may include fluorosilane-based gases such as tetrafluorosilane ($SiF_4$) and difluorosilane ($SiH_2F_2$), bromosilane-based gases such as tetrabromosilane ($SiBr_4$) and dibromosilane ($SiH_2Br_2$), and iodosilane-based gases such as tetraiodosilane ($SiI_4$) and diiodosilane ($SiH_2I_2$). One or more selected from the group of these substances may be used as the first precursor.

[First Reactant Supply Step]

After the first precursor supply step is completed, a first reactant (first reaction gas) as a first film-forming agent is supplied to the wafer 200, that is, the wafer 200 with the first layer selectively formed on the second surface, at the first temperature. In the present disclosure, an example in which a nitrogen (N)-containing gas (N-containing substance) is used as the first reactant (first reaction gas) will be described.

Specifically, the valve 243c is opened to allow the first reactant to flow through the gas supply pipe 232c. A flow rate of the first reactant is regulated by the MFC 241c, and the first reactant is supplied into the process chamber 201 via the nozzle 249c and is exhausted via the exhaust port 231a. In this operation, the first reactant is supplied to the wafer 200 from the lateral side of the wafer 200 (first reactant supply). At this time, the valves 243f to 243h may be opened to supply an inert gas into the process chamber 201 via the nozzles 249a to 249c, respectively.

By supplying the first reactant to the wafer 200 under a processing condition to be described below, it is possible to nitride at least a portion of the first layer formed on the second surface of the wafer 200 in the first precursor supply step. As a result, a second layer formed by nitriding the first layer is formed on the second surface.

In this step, it is possible to allow the formation of the second layer to be performed under a low temperature condition as described below, that is, at the first temperature. In this way, by forming the second layer under the low temperature condition as described below, that is, at the first temperature, the molecules and atoms constituting the inhibitor layer formed on the first surface may be maintained without being extinguished (desorbed) from the first surface.

A processing condition when supplying the first reactant in the first reactant supply step is exemplified as follows.

Processing temperature (first temperature): 350 to 600 degrees C, specifically 400 to 550 degrees C,
Processing pressure: 1 to 4,000 Pa, specifically 1 to 1,333 Pa,
First reactant supply flow rate: 0.01 to 10 slm,
First reactant supply time: 1 to 120 seconds, specifically 5 to 80 seconds, and
Inert gas supply flow rate (for each gas supply pipe): 0 to 20 slm.

After the first layer formed on the second surface of the wafer 200 is nitrided and changed (converted) into the second layer, the valve 243c is closed to stop the supply of the first reactant into the process chamber 201. Then, gaseous substance and the like remaining in the process chamber 201 are removed from the process chamber 201 according to the same processing procedure and processing condition as the purging in the cleaning step (purging). The processing temperature when performing the purging in this step may be the same as the processing temperature when supplying the first reactant.

As the first reactant, for example, a N-containing gas (N-containing substance) may be used. As the N-containing gas (N-containing substance), for example, a N- and hydrogen (H)-containing gas and a C- and N-containing gas may be used. As the N- and H-containing gas, for example, a hydrogen nitride-based gas containing a N-H bond may be used. As the C- and N-containing gas, an amine-based gas and an organic hydrazine-based gas may be used.

Examples of the first reactant may include ammonia ($NH_3$), hydrazine ($N_2H_4$), diazene ($N_2H_2$), $N_3H_8$, and the like. Further, examples of the first reactant may include monoethylamine ($C_2H_5NH_2$, abbreviation: MEA), diethylamine (($C_2H_5$)$_2$NH, abbreviation: DEA), triethylamine (($C_2H_5$)$_3$N, abbreviation: TEA), monomethylamine ($CH_3NH_2$, abbreviation: MMA), dimethylamine (($CH_3$)$_2$NH, abbreviation: DMA), trimethylamine (($CH_3$)$_3$N, abbreviation: TMA), and the like. Further, examples of the first reactant may include monomethylhydrazine (($CH_3$)$HN_2H_2$, abbreviation: MMH), dimethylhydrazine (($CH_3$)$_2N_2H_2$, abbreviation: DMH), trimethylhydrazine (($CH_3$)$_2N_2(CH_3)H$, abbreviation: TMH), and the like. One or more selected from the group of these substances may be used as the first reactant.

[Performing Predetermined Number of Times]

By performing a cycle a predetermined number of times (m times, where m is an integer of 1 or more), the cycle including non-simultaneously, that is, alternately without synchronization, performing the above-described first precursor supply step and first reactant supply step, it is possible to selectively (preferentially) form the first film on the second surface among the first surface and the second surface of the wafer 200, as shown in FIG. 5C. For example, when the above-described first precursor and first reactant are used, a SiN film or a silicon carbonitride film (SiCN film) may be selectively grown as the first film on the second surface. The above-described cycle may be performed a plurality of times. That is, a thickness of the second layer formed per cycle may be set to be smaller than a desired film thickness of the first film, and the above-described cycle may be performed a plurality of times until a thickness of the first film formed by stacking second layers reaches the desired film thickness.

As described above, by performing the above-described cycle the predetermined number of times, the first film may be selectively grown on the second surface of the wafer 200. At this time, since the inhibitor layer is formed on the first surface of the wafer 200, it is possible to suppress the growth of the first film on the first surface. That is, by performing the above-described cycle the predetermined number of times, it is possible to promote the growth of the first film on the second surface while suppressing the growth of the first film on the first surface.

Further, as described above, when the first precursor supply step and the first reactant supply step are performed, since the inhibitor layer formed on the first surface is maintained on the first surface as described above, it is possible to suppress the growth of the first film on the first surface. However, when the formation of the inhibitor layer on the first surface is insufficient for some reasons, the formation and growth of the first film on the first surface may occur very slightly. However, even in this case, the thickness of the first film formed on the first surface is much thinner than the thickness of the first film formed on the second surface. As used herein, "high selectivity in selective growth" means to include a case where a very thin film is formed on the first surface but a film much thicker than the film formed on the first surface is formed on the second surface, as well as a case where the first film is formed on the second surface with no first film formed on the first surface.

Further, in the first film-forming step in which the first precursor supply step and the first reactant supply step are performed, the processing conditions may be controlled such that a reactivity between the first film-forming agent (the first precursor and the first reactant) and the inhibitor layer in the first film-forming step is lower than a reactivity between the second film-forming agent (the second precursor and the second reactant) and the inhibitor layer in the second film-forming step. This makes it possible to suppress invalidation and/or removal (desorption) of the inhibitor layer when forming the first film, thereby forming the first film on the second surface with high selectivity.

(Second Film-Forming Step)

After performing the first film-forming step, a second film-forming agent, at least a portion of which being provided with a second energy higher than the first energy, is supplied to the wafer 200 to form a second film on the first film formed on the second surface of the wafer 200. That is, the second film-forming agent, at least a portion of which being provided with the second energy higher than the first energy, is supplied to the wafer 200 so as to react with the first film formed on the second surface to selectively (preferentially) form a film on the first film. Specifically, the following second precursor supply step and second reactant supply step are sequentially executed. In the following example, a second precursor and a second reactant are each supplied at a second temperature higher than the first temperature. That is, in the following example, each of the second precursor and the second reactant is heated at the second temperature higher than the first temperature, thereby providing the second energy to each of the second precursor and the second reactant. In this case, at least one selected from the group of the second precursor and the second reactant may be excited (thermally excited) by the second energy. In the second precursor supply step and the second reactant supply step, the output of the heater 207 is regulated to keep a processing temperature, that is, the second temperature, higher than the processing temperature in the first precursor supply step and the first reactant supply step, that is, the first temperature, as shown in FIG. 4.

[Second Precursor Supply Step]

In this step, a second precursor (second precursor gas) as a second film-forming agent is supplied to the wafer 200 subjected to the first film-forming step, that is, the wafer 200 with the first film selectively formed on the second surface, at the second temperature. In the present disclosure, an example in which a precursor being different in molecular structure from the first precursor is used as the second precursor will be described.
Specifically, the valve 243d is opened to allow the second precursor to flow through the gas supply pipe 232a. A flow rate of the second precursor is regulated by the MFC 241d, and the second precursor is supplied into the process chamber 201 via the nozzle 249a and is exhausted via the exhaust port 231a. In this operation, the second precursor is supplied to the wafer 200 from the lateral side of the wafer 200 (second precursor supply). At this time, the valves 243f to 243h may be opened to allow the inert gas to be supplied into the process chamber 201 via the nozzles 249a to 249c, respectively.
By supplying the second precursor to the wafer 200 under a processing condition to be described below, at least a portion of a molecular structure of molecules constituting the second precursor may be selectively chemisorbed on the first film formed on the second surface. Thus, a third layer is selectively formed on the first film formed on the second surface. The third layer contains at least a portion of the molecular structure of the molecules constituting the second precursor, which are residues of the second precursor. That is, the third layer contains at least a portion of atoms constituting the second precursor.
In this step, the third layer may be formed under a relatively high temperature condition as described below, that is, at the second temperature. By forming the third layer at the second temperature in this way, it is possible to efficiently thermally decompose (vapor-phase decompose) the second precursor, thereby forming the third layer with few impurities and high density.
Further, by forming the third layer under a relatively high temperature condition as described below, that is, at the second temperature, it is possible to invalidate and/or remove (desorb) at least a portion of the inhibitor layer remaining on the first surface. That is, it is possible to perform at least one selected from the group of invalidation and removal of at least a portion of the inhibitor layer remaining on the first surface. The invalidation of the inhibitor layer means that a molecular structure of molecules, an arrangement structure of atoms constituting the inhibitor layer, or the like is changed to enable adsorption of the second film-forming agent on the first surface or a reaction between the first surface and the second film-forming agent. Therefore, in this step, at least a portion of the molecular structure of molecules constituting the second precursor may be adsorbed on a portion of the first surface of the wafer 200. However, even in that case, an amount of the adsorption is very small and an amount of the adsorption on the first film formed on the second surface of the wafer 200 is overwhelmingly large. This is because at the second temperature, the invalidation and/or removal of at least a portion of the inhibitor layer does not proceed abruptly, but rather slowly and gradually.
A processing condition when supplying the second precursor in the second precursor supply step is exemplified as follows.

Processing temperature (second temperature): 450 to 800 degrees C, specifically 600 to 700 degrees C,
Processing pressure: 1 to 2,000 Pa, specifically 10 to 1,333 Pa,
Second precursor supply flow rate: 0.001 to 2 slm, specifically 0.01 to 1 slm,
Second precursor supply time: 1 second to 180 seconds, specifically 10 seconds to 120 seconds, and
Inert gas supply flow rate (for each gas supply pipe): 0 to 20 slm.

After selectively forming the third layer on the first film formed on the second surface of the wafer 200, the valve 243d is closed to stop the supply of the second precursor into the process chamber 201. Then, a gaseous substance and the like remaining in the process chamber 201 are removed from the process chamber 201 according to the same processing procedure and processing condition as the purging in the cleaning step (purging). The processing temperature when performing the purging in this step may be the same as the processing temperature when supplying the second precursor.

As the second precursor, for example, a compound being different in molecular structure from the first precursor may be used. A thermal decomposition temperature of the second precursor may be lower than a thermal decomposition temperature of the first precursor. Further, under the same condition, a reactivity of the second precursor may be higher than a reactivity of the first precursor. By using such a second precursor, it is possible to efficiently form the third layer with high density. Moreover, as the second precursor, a precursor whose reactivity with the inhibitor layer formed in the modifying step is higher than a reactivity between the first precursor and the inhibitor layer may be used. By using such a second precursor, it is possible to invalidate and/or remove the inhibitor layer efficiently and effectively.

Further, as the second precursor, for example, when forming the second film containing atoms X in the second film-forming step, a gas (substance) containing one or more atoms X in one molecule may be used. Further, a gas (substance) containing a chemical bond between atoms X may be used as the second precursor. The atoms X are the same as the atoms X in the above-described first precursor. Specifically, as the second precursor, for example, a Si-containing gas (Si-containing substance) containing one or more Si's in one molecule may be used, and more specifically, a Si-containing gas (Si-containing substance) containing two or more Si's in one molecule may be used. Further, as the second precursor, for example, a Si-containing gas (Si-containing substance) that contains a chemical bond between Si's, that is, a Si-Si bond may be used.

As the second precursor, for example, the same Si- and halogen-containing gas (Si- and halogen-containing substance) as the various first precursors exemplified in the above-described first precursor supply step may be used. However, as the second precursor, a Si- and halogen-containing gas (Si- and halogen-containing substance) being different in molecular structure from the first precursor may be selected.

Further, examples of the second precursor may include aminosilane-based gases such as tetrakis(dimethylamino)silane ($Si[N(CH_3)_2]_4$, abbreviation: 4DMAS), tris(dimethylamino)silane ($Si[N(CH_3)_2]_3H$, abbreviation: 3DMAS), bis(diethylamino)silane ($Si[N(C_2H_5)_2]_2H_2$, abbreviation: BDEAS), bis(tert-butylamino)silane ($SiH_2[NH(C_4H_9)]_2$, abbreviation: BTBAS), (diisobutylamino)silane ($SiH_3[N(C_4H_9)_2]$, abbreviation: DIBAS), and (diisopropylamino)silane ($SiH_3[N(C_3H_7)_2]$, abbreviation: DIPAS). One or more selected from the group of these gases may be used as the second precursor.

[Second Reactant Supply Step]

After the second precursor supply step is completed, a second reactant (second reaction gas) as a second film-forming agent is supplied to the wafer 200, that is, the wafer 200 with the third layer selectively formed on the first film formed on the second surface, at the second temperature. In the present disclosure, an example in which a N-containing gas (N-containing substance) is used as the second reactant (second reaction gas) will be described. This step may be performed under the same processing procedure as the above-described first reactant supply step under the following processing condition. This step makes it possible to nitride at least a portion of the third layer formed on the first film in the second precursor supply step. As a result, a fourth layer formed by nitriding the third layer is formed on the first film formed on the second surface.

In this step, the fourth layer may be formed under a relatively high temperature condition as described below, that is, at the second temperature. By nitriding the third layer at the second temperature in this way, impurities may be removed and defects may be repaired, making it possible to change the third layer to the fourth layer with fewer impurities and defects and higher density. In addition, in this step, the fourth layer may be formed under a relatively high temperature condition as described below, that is, at the second temperature, making it possible to invalidate and/or remove at least a portion of the inhibitor layer remaining on the first surface. However, as in the second precursor supply step, the invalidation and/or removal of at least a portion of the inhibitor layer does not proceed abruptly, but rather slowly and gradually at the second temperature in this step.

A processing condition when supplying the second reactant in the second reactant supply step is exemplified as follows.

Processing temperature (second temperature): 450 to 800 degrees C, specifically 600 to 700 degrees C,
Processing pressure: 1 to 4,000 Pa, specifically 1 to 1,333 Pa,
Second reactant supply flow rate: 0.01 to 10 slm,
Second reactant supply time: 1 to 120 seconds, specifically 5 to 80 seconds, and
Inert gas supply flow rate (for each gas supply pipe): 0 to 20 slm.

After nitriding the third layer formed on the first film formed on the second surface of the wafer 200 to change (convert) the third layer to the fourth layer, a gas and the like remaining in the process chamber 201 are removed from the process chamber 201 according to the same processing procedure as the purging in the cleaning step (purging). Further, the processing temperature when performing the purging in this step may be the same as the processing temperature when supplying the second reactant.

As the second reactant, for example, the same N-containing gas (N-containing substance) as the various first reactants exemplified in the first reactant supply step may be used. The first reactant and the second reactant may be different from each other or the same as each other in molecular structure. When the molecular structures of the first reactant and the second reactant are the same, it is possible to reduce types of substances used. As a result, it is possible to simplify the processing sequence, thereby simplifying a supply system in the substrate processing apparatus and reducing an apparatus cost.

[Performing Predetermined Number of Times]

By performing a cycle a predetermined number of times (n times, where n is an integer of 1 or more), the cycle including non-simultaneously, that is, alternately without synchronization, performing the above-described second precursor supply step and second reactant supply step, it is possible to selectively form the second film on the first film formed on the second surface of the wafer 200, as shown in FIG. 5D. For example, when the above-described second precursor and second reactant are used, a SiN film or a SiCN film may be selectively grown as the second film on the first film. Further, the second film is provided to cover the entire surface of the first film. That is, by forming the second film on the first film, the surface of the first film is covered with the second film and therefore is not exposed. The above-described cycle may be performed a plurality of times. That is, a thickness of the fourth layer formed per cycle may be set to be smaller than a desired film thickness of the second film, and the above-described cycle may be performed a plurality of times until the thickness of the second film formed by stacking the fourth layers reaches the desired film thickness.

As described above, by performing the above-described cycle a predetermined number of times, at least a portion of the inhibitor layer remaining on the first surface of the wafer 200 may be invalidated and/or removed, in parallel to the formation of the second film on the first film formed on the second surface of the wafer 200. This makes it possible to omit a step of invalidating and/or removing the inhibitor layer after performing the second film-forming step. Alternatively, even in a case where such a step is performed, it is possible to reduce a load in the process. Further, by performing the above-described cycle a predetermined number of times, a second film thinner than the second film formed on the first film may be formed on the first surface on which the inhibitor layer was invalidated and/or removed (desorbed). FIG. 5D shows an example in which a second film thinner than the second film formed on the first film is formed on the first surface exposed by desorbing the inhibitor layer.

Further, in the second film-forming step in which the second precursor supply step and the second reactant supply step are performed, the processing condition may be controlled such that a reactivity between the second film-forming agent (the second precursor and the second reactant) and the inhibitor layer in the second film-forming step is higher than a reactivity between the first film-forming agent (the first precursor and the first reactant) and the inhibitor layer in the first film-forming step. This makes it possible to efficiently and effectively invalidate and/or remove the inhibitor layer when forming the second film.

As described above, the second film formed on the first film in the second film-forming step becomes high in film density because impurities are removed and defects are repaired during the formation of the second film. Therefore, an oxidation resistance of the second film is higher than that of the first film. By forming such a second film with high oxidation resistance on the first film, the second film serves as an oxidation blocking layer (oxidation barrier layer), thereby suppressing oxidation of the first film due to exposure to the atmosphere. Further, since the oxidation resistance of the second film may be increased, oxidation of the second film itself due to exposure to the atmosphere may be suppressed. As a result, it is possible to suppress oxidation of a laminated film (laminated body) of the first film and the second film selectively formed on the second surface due to exposure to the atmosphere. It is also possible to suppress deterioration in processing resistance and deterioration in electrical characteristics due to the oxidation of the laminated film of the first film and the second film due to exposure to the atmosphere. Since the first film is also heated at the second temperature when performing the second film-forming step, a portion of the impurities contained in the first film may be removed and a portion of the defects contained in the first film may be repaired, thereby increasing the film density of the first film. However, even in that case, the second film is lower in impurity concentration, higher in film density, and higher in oxidation resistance than the first film.

It is desirable to set the thickness of the second film formed in the second film-forming step to be equal to or less than the thickness of the first film. By setting the thickness of the second film to be equal to or less than the thickness of the first film, it is possible to prevent the second film from being formed to be thick on the first surface on which the inhibitor layer was invalidated and/or removed, in the second film-forming step. Further, by making the thickness of the second film thinner than the thickness of the first film, this effect may be obtained more sufficiently.

Further, the thickness of the second film formed in the second film-forming step may be 0.3 nm or more and 5 nm or less, or may be 0.5 nm or more and 4 nm or less. In a case where the thickness of the second film is less than 0.3 nm, the oxidation resistance of the second film may be insufficient, whereby it may not be possible to sufficiently suppress deterioration of the processing resistance and deterioration of the electrical characteristics due to oxidation by atmospheric exposure of the laminated film of the first film and the second film. In contrast, by setting the thickness of the second film to 0.3 nm or more, it is possible to sufficiently secure the oxidation resistance of the second film, which makes it possible to sufficiently suppress deterioration of the processing resistance and deterioration of the electrical characteristics due to oxidation by the atmospheric exposure of the laminated film of the first film and the second film. This effect may be further enhanced by setting the thickness of the second film to 0.5 nm or more.

Further, when the thickness of the second film is more than 5 nm, the second film may be formed to be thick on the first surface after the inhibitor layer is invalidated and/or removed when forming the second film. In contrast, by setting the thickness of the second film to 5 nm or less, when forming the second film, it is possible to prevent the second film from being formed to be thick on the first surface after the inhibitor layer is invalidated and/or removed. This effect may be further enhanced by setting the thickness of the second film to 4 nm or less.

In this regard, in the second film-forming step, the second film may be formed with a thickness of 0.3 nm or more and 5 nm or less, or may be formed with a thickness of 0.5nm or more and 4nm or less.

Further, by controlling the processing condition in each of the above-described second precursor supply step and second reactant supply step and the number of times (m times) the above-described cycle is performed, desorption and removal of the inhibitor layer formed on the first surface may be completed simultaneously with completion of formation of the second film with a desired thickness on the first film formed on the second surface. That is, an end point of a process of forming the second film on the first film formed on the second surface may be matched with an end point of a process of desorbing and removing the inhibitor layer formed on the first surface. This makes it possible to omit an etching process of removing the inhibitor layer remaining on the first surface after performing the second film-forming step.

Further, as shown in FIG. 5D, when the thin second film is formed on the first surface, the second film formed on the first surface may be removed by an etching process after performing the second film-forming step. When the second film formed on the first surface is removed by the etching process, the second film formed on the first film is also etched, but an amount of the etching is very small and most of the second film formed on the first film may be left. Therefore, oxidation resistance of the second film formed on the first film is not deteriorated. This is because the second film formed on the first film is much thicker than the second film formed on the first surface. Further, the second film formed on the first surface may not be removed, and such an etching process may be omitted.

(Heat Treating Step)

After performing the second film-forming step, the wafer 200 is heat-treated. In this operation, the output of the heater 207 is regulated such that the internal temperature of the process chamber 201, that is, the temperature of the wafer 200 after performing the second film-forming step, is equal to or higher than the second temperature. Specifically, as shown in FIG. 4, the output of the heater 207 is regulated such that the temperature of the wafer 200 after performing the second film-forming step is higher than the second temperature.

By performing the heat treatment (annealing process) on the wafer 200, impurities remaining in each of the first film and the second film may be removed and defects may be repaired, thereby making a density of each of the first film and the second film higher than that before the heat treatment. As a result, each of the first film and the second film may be made harder than that before the heat treatment. Thus, the oxidation resistance or the processing resistance, that is, the etching resistance of each of the first film and the second film may be improved. Further, the annealing process, that is, the heat treating step, may be omitted when impurity removal, defect repair, film hardening, or the like may not be performed for the first film and the second film.

Further, in a case where the inhibitor layer is not sufficiently invalidated and/or removed in the second film-forming step and remains on the first surface of the wafer 200 after performing the second film-forming step, by performing the heat treating step, the remaining inhibitor layer may also be invalidated and/or removed by the heat treatment. This makes it possible to desorb and remove the inhibitor layer remaining on the first surface. That is, according to the heat treating step, it is also possible to remove the inhibitor layer remaining on the first surface and expose the first surface.

Further, the heat treating step may be performed in a state where an inert gas is supplied into the process chamber 201, or may be performed in a state where reactive substance such as an oxidizing agent (oxidizing gas) such as an oxygen ($O_2$) gas, a nitriding agent (nitriding gas) such as an ammonia ($NH_3$) gas, or a reducing agent (reducing gas) such as a hydrogen ($H_2$) gas is supplied into the process chamber 201. In this case, the inert gas and the reactive substance such as the oxidizing agent (oxidizing gas), the nitriding agent (nitriding gas), or the reducing agent (reducing gas) are also referred to as an assist substance.

A processing condition when performing the heat treatment in the heat treating step is exemplified as follows.

Processing temperature: 200 to 1,000 degrees C, specifically 400 to 700 degrees C,
Processing pressure: 1 to 120,000Pa,
Processing time: 1 to 18,000 seconds, and
Assist substance supply flow rate: 0 to 50 slm.

(After-Purge and Returning to Atmospheric Pressure)

After the heat treating step is completed, an inert gas as a purge gas is supplied into the process chamber 201 from each of the nozzles 249a to 249c and is exhausted via the exhaust port 231a. Thus, the inside of the process chamber 201 is purged such that gases, reaction byproducts, and the like remaining in the process chamber 201 are removed from the inside of the process chamber 201 (after-purge). Thereafter, the internal atmosphere of the process chamber 201 is replaced with an inert gas (inert gas replacement) and the internal pressure of the process chamber 201 is returned to the atmospheric pressure (returning to atmospheric pressure).

(Boat Unloading and Wafer Discharging)

Thereafter, the seal cap 219 is moved down by the boat elevator 115 to open the lower end of the manifold 209. Then, the processed wafers 200 supported by the boat 217 are unloaded from the lower end of the manifold 209 to the outside of the reaction tube 203 (boat unloading). After the boat is unloaded, the shutter 219s is moved and the lower end opening of the manifold 209 is sealed by the shutter 219s via the O-ring 220c (shutter closing). The processed wafers 200 are unloaded from the reaction tube 203 and are then discharged from the boat 217 (wafer discharging).

As described above, the cleaning step, the modifying step, the first film-forming step, the second film-forming step, and the heat treating step may be performed in the same process chamber (in-situ). As a result, after the surface of the wafer 200 is cleaned in the cleaning step (after the native oxide film is removed), without the wafer 200 exposed to the atmosphere, that is, with the surface of the wafer 200 kept clean, the modifying step, the first film-forming step, the second film-forming step, and the heat treating step may be performed, thereby making it possible to properly perform the selective growth. That is, by performing these steps in the same process chamber, it is possible to perform the selective growth with high selectivity. Further, when the cleaning step may be omitted as described above, the modifying step, the first film-forming step, the second film-forming step, and the heat treating step may be performed in the same process chamber. Further, when the heat treating step may be omitted as described above, the modifying step, the first film-forming step, and the second film-forming step may be performed in the same process chamber.

Further, as described above, when at least the modifying step, the first film-forming step, and the second film-forming step are performed in the same process chamber, an unloading step of unloading the wafer 200 subjected to the modifying step, the first film-forming step, and the second film-forming step from the inside of the process chamber to the outside of the process chamber is performed. The wafer 200 unloaded to the outside of the process chamber in the unloading step may be exposed to the atmosphere, even in which case, since the second film being higher in oxidation resistance than the first film is formed on the first film formed on the wafer 200, oxidation of the first film due to exposure to the atmosphere may be suppressed. Further, since the oxidation resistance of the second film may be increased, the oxidation of the second film itself due to exposure to the atmosphere may be suppressed. As a result, it is possible to suppress oxidation of the laminated film of the first film and the second film due to exposure to the atmosphere. Accordingly, it is possible to suppress deterioration in the processing resistance and deterioration in the electrical characteristics due to the oxidation of the laminated film of the first film and the second film due to exposure to the atmosphere.

(3) Effects of the Embodiments of the present disclosure

According to the embodiments of the present disclosure, one or more selected from the group of effects set forth below may be achieved.

In the second film-forming step, by using the second film-forming agent to which the second energy higher than the first energy provided to the first film-forming agent in the first film-forming step is supplied, the second film being higher in oxidation resistance than the first film may be formed on the first film formed on the second surface. By forming the second film being higher in oxidation resistance than the first film on the first film, oxidation of the first film due to exposure to the atmosphere may be suppressed. Further, since the oxidation resistance of the second film may be increased, the oxidation of the second film itself due to exposure to the atmosphere may be suppressed. As a result, it is possible to suppress oxidation of the laminated film (laminated body) of the first film and the second film due to exposure to the atmosphere. Accordingly, it is possible to suppress deterioration in the processing resistance and deterioration in the electrical characteristics due to the oxidation of the laminated film of the first film and the second film due to exposure to the atmosphere.

In the first film-forming step, by using the first film-forming agent to which the first energy is provided, it is possible to suppress the invalidation and/or removal (desorption) of the inhibitor layer when forming the first film, thereby making it possible to form the first film with high selectivity on the second surface. Further, in the second film-forming step, by using the second film-forming agent to which the second energy higher than the first energy is provided, it is possible to invalidate and/or remove the inhibitor layer when forming the second film. This makes it possible to omit a step of invalidating and/or removing the inhibitor layer after performing the second film-forming step. Alternatively, even in a case where such a step is performed, it is possible to reduce a load in such a step.

The first precursor and the first reactant may be used as the first film-forming agent in the first film-forming step, and the second precursor, which is different in molecular structure from the first precursor, and the second reactant may be used as the second film-forming agent in the second film-forming step. By making the molecular structure of the second precursor different from the molecular structure of the first precursor, it is possible to obtain the above-described effects efficiently and effectively. A thermal decomposition temperature of the second precursor may be lower than a thermal decomposition temperature of the first precursor, and a reactivity of the second precursor may be higher than a reactivity of the first precursor under the same condition. These make it possible to obtain the above-described effects more efficiently and effectively.

When each of the first film and the second film contains atoms X, the first precursor may contain one atom X in one molecule, and the second precursor may contain two or more atoms X in one molecule. Further, when each of the first film and the second film contains atoms X, the first precursor may contain no chemical bond between atoms X and the second precursor may contain the chemical bond between atoms X. These make it possible to obtain the above-described effects more efficiently and effectively.

By using, as the second precursor, a precursor whose reactivity with the inhibitor layer is higher than a reactivity between the first precursor and the inhibitor layer, it is possible to invalidate and/or remove the inhibitor layer efficiently or effectively when forming the second film. In other words, by using, as the first precursor, a precursor whose reactivity with the inhibitor layer is lower than the reactivity between the second precursor and the inhibitor layer, it is possible to suppress the invalidation and/or removal of the inhibitor layer efficiently or effectively when forming the first film.

The processing conditions in the first film-forming step and the second film-forming step may be controlled such that the reactivity between the second film-forming agent and the inhibitor layer in the second film-forming step is higher than the reactivity between the first film-forming agent and the inhibitor layer in the first film-forming step. This makes it possible to suppress the invalidation and/or removal of the inhibitor layer efficiently and effectively when forming the first film, which makes it possible to form the first film with high selectivity on the second surface. Further, it is possible to invalidate and/or remove the inhibitor layer efficiently and effectively when forming the second film.

The first precursor and the first reactant as the first film-forming agent may be alternately supplied to the wafer 200 in the first film-forming step and the second precursor and the second reactant as the second film-forming agent may be alternately supplied to the wafer 200 in the second film-forming step. As a result, film thickness controllability of the first film and the second film may be enhanced. It is also possible to improve step coverage characteristics.

The first film and the second film may be the same as each other in component. For example, as described above, both the first film and the second film may be nitride films. That is, the first film may be formed on the second surface, and the second film being the same in component as the first film may be formed on the first film. For example, as described above, the first film, which is a nitride film, may be formed on the second surface, and the second film, which is also a nitride film, may be formed on the first film. As a result, the above-described effects may be obtained more remarkably.

(4) Modifications

The processing sequence in the embodiments of the present disclosure may be changed as in the following modifications. These modifications may be used in proper combination. Unless otherwise stated, a processing procedure and a processing condition in each step of each modification may be the same as those in each step of the above-described processing sequence.

(First Modification)

The first film-forming step and the second film-forming step may be changed as in the processing sequences shown below. That is, the first film-forming agent which is not excited into a plasma state (in a plasma non-excited state) may be supplied to the wafer 200 in the first film-forming step, and the second film-forming agent, at least a portion of which is excited into a plasma state (in a plasma-excited state) may be supplied to the wafer 200 in the second film-forming step. By doing so, in the second film-forming step in this modification, it is possible to provide the second energy, which is higher than the first energy provided to at least a portion of the first film-forming agent, to at least a portion of the second film-forming agent. The notation "second reactant*" in the following processing sequences means the second reactant excited into a plasma state.

$$\text{Modifying agent} \rightarrow (\text{First precursor} \rightarrow \text{First reactant}) \times m \rightarrow (\text{Second precursor} \rightarrow$$
$$\text{Second reactant}^*) \times n$$

$$\text{Modifying agent} \rightarrow (\text{First precursor} \rightarrow \text{First reactant}) \times m \rightarrow (\text{Second precursor} \rightarrow$$
$$\text{Second reactant}^*) \times n \rightarrow \text{Heat treatment}$$

$$\text{Cleaning agent} \rightarrow \text{Modifying agent} \rightarrow (\text{First precursor} \rightarrow \text{First reactant}) \times m \rightarrow (\text{Second}$$
$$\text{precursor} \rightarrow \text{Second reactant}^*) \times n$$

$$\text{Cleaning agent} \rightarrow \text{Modifying agent} \rightarrow (\text{First precursor} \rightarrow \text{First reactant}) \times m \rightarrow (\text{Second}$$
$$\text{precursor} \rightarrow \text{Second reactant}^*) \times n \rightarrow \text{Heat treatment}$$

The processing procedure and processing condition of the first film-forming step in this modification may be the same as those of the first film-forming step in the above-described processing sequence. Further, the processing procedure and processing condition of the second film-forming step in this modification may be the same as those of the second film-forming step in the above-described processing sequence, except that the second reactant is excited into the plasma state. However, in this modification, the processing temperature in the second film-forming step may be made the same as the processing temperature in the first film-forming step by using plasma energy. For example, the above-mentioned RPU 270 installed at the downstream side of the connecting portion of the gas supply pipe 232c with the gas supply pipe 232h may be used to excite the second reactant into the plasma state. The RPU 270 is configured to be capable of exciting a gas inside the RPU 270 into plasma by applying radio frequency (RF) power, that is, exciting the gas into the plasma state. Thus, by using the RPU 270, the second reactant supplied from the gas supply pipe 232c is excited into a plasma state, and the second reactant excited into the plasma state is supplied into the process chamber 201. When the second reactant is excited into the plasma state, the RF power may be, for example, 1 to 1,500 W.

This modification also obtains the same effects as in the above-described embodiments. Further, in this modification, the reactivity between the second film-forming agent and the inhibitor layer in the second film-forming step may be made higher than the reactivity between the first film-forming agent and the inhibitor layer in the first film-forming step. This makes it possible to suppress the invalidation and/or removal of the inhibitor layer efficiently and effectively when forming the first film, which makes it possible to form the first film with high selectivity on the second surface. Further, it is possible to invalidate and/or remove the inhibitor layer efficiently and effectively when forming the second film. Further, in the case of this modification, the processing temperature in the first film-forming step and the processing temperature in the second film-forming step may be the same. As a result, the processing temperature may not be changed between in the first film-forming step and in the second film-forming step, which makes it possible to shorten a processing time.

(Second Modification)

In the second precursor supply step, the second precursor being the same in molecular structure as the first precursor may be used. That is, precursors with the same molecular structure may be used in the first precursor supply step and the second precursor supply step. By making the molecular structures of the first precursor and the second precursor the same, it is possible to reduce types of substances used. As a result, it is possible to simplify the processing sequence, thereby simplifying a supply system in the substrate processing apparatus and reducing an apparatus cost.

This modification also obtains the same effects as in the above-described embodiments.

(Third Modification)

The inhibitor molecule may contain at least one selected from the group of a fluorocarbon group and a fluorosilyl group. That is, the inhibitor layer formed on the first surface may contain at least one selected from the group of fluorocarbon termination and fluorosilyl termination.

When the inhibitor molecule contains the fluorocarbon group, for example, the aforementioned compounds with the structure in which the amino group and the alkyl group are directly bonded to Si, and the aforementioned F-containing gas may be used as the modifying agent, and these gases may be sequentially or simultaneously supplied to the wafer 200.

Further, when the inhibitor molecule contains the fluorocarbon group, for example, among the aforementioned compounds with the structure in which the amino group and the alkyl group are directly bonded to Si, a gas obtained by substituting some or the entirety of H's of the alkyl group with F may be used as the modifying agent. At least one selected from the group of these gases causes the inhibitor layer formed on the first surface to contain the fluorocarbon termination.

Further, when the inhibitor molecule contains the fluorosilyl group, for example, the above-mentioned aminosilane-based gas and the above-mentioned F-containing gas are used as modifying agent, and these gases may be sequentially or simultaneously supplied to the wafer 200. Thus, the inhibitor layer formed on the first surface includes the fluorosilyl termination.

In this modification, a processing condition when supplying the compound with the structure in which the amino group and the alkyl group are directly bonded to Si or the aminosilane-based gas is exemplified as follows.

Processing temperature: room temperature (25 degrees C) to 600 degrees C, specifically room temperature to 450 degrees C,
Processing pressure: 1 to 2,000 Pa, specifically 1 to 1,000 Pa,
Compound or gas supply time: 1 second to 60 minutes,
Compound or gas supply flow rate: 0.001 to 2 slm, specifically 0.001 to 0.5 slm, and
Inert gas supply flow rate (for each gas supply pipe): 0 to 20 slm.

In this modification, a processing condition when supplying the F-containing gas is exemplified as follows.

Processing temperature: room temperature (25 degrees C) to 550 degrees C, specifically room temperature to 450 degrees C,
Processing pressure: 1 to 2,000 Pa, specifically 1 to 1,000 Pa,
F-containing gas supply time: 1 second to 60 minutes,
F-containing gas supply flow rate: 0.001 to 2 slm, specifically 0.001 to 0.5 slm, and
Inert gas supply flow rate (for each gas supply pipe): 0 to 20 slm.

In any of these cases, since the outermost surface of the inhibitor layer is F, the surface may also be referred to as being F-terminated. The fluorocarbon group or fluorosilyl group terminating the first surface may prevent adsorption of the first film-forming agent, especially the first precursor, on the first surface in the film-forming step to inhibit (suppress) the progress of the film-forming reaction on the first surface. This modification also obtains the same effects as in the above-described embodiments.

(Fourth Modification)

At least one selected from the group of the cleaning step, the modifying step, the first film-forming step, the second film-forming step, and the heat treating step may be performed by using a cluster apparatus without exposing the wafer 200 to the atmosphere. For example, the modifying step, the first film-forming step, and the second film-forming step may be continuously performed by using the cluster apparatus without exposing the wafer 200 to the atmosphere. Further, for example, the modifying step, the first film-forming step, the second film-forming step, and the heat treating step may be continuously performed by using the cluster apparatus without exposing the wafer 200 to the atmosphere. In these cases, each step is performed in a process chamber. Even in these cases, by performing each step, the wafer 200 with the laminated film of the first film and the second film formed on the second surface may be exposed to the atmosphere after unloading the wafer 200 from the cluster apparatus. However, even in these cases, since the second film being higher in oxidation resistance than the first film is formed on the first film, oxidation of the laminated film of the first film and the second film may be suppressed, thereby obtaining the same effects as in the above-described embodiments.

<Other Embodiments of the Present Disclosure>

The embodiments of the present disclosure are specifically described above. However, the present disclosure is not limited to the above-described embodiments, and various changes may be made without departing from the gist thereof.

For example, the wafer 200 may include at least one selected from the group of an oxygen-containing film and a metal-containing film as the first surface (the first base), and may include at least one selected from the group of an oxygen-free film and a metal-free film as the second surface (the second base). Further, for example, the wafer 200 may include a plurality of types of regions being different in material from one another as the first surface (the first base), and may include a plurality of types of regions being different in material from one another as the second surface (the second base). The regions (bases) constituting the first surface and the second surface may include, in addition to the above-mentioned SiO film and SiN film, films containing semiconductor elements, such as a silicon oxycarbonitride film (SiOCN film), a silicon oxycarbide film (SiOC film), a silicon oxynitride film (SiON film), a silicon carbonitride film (SiCN film), a silicon carbide film (SiC film), a silicon borocarbonitride film (SiBCN film), a silicon boronitride film (SiBN film), a silicon borocarbide film (SiBC film), a silicon film (Si film), a germanium film (Ge film), and a silicon germanium film (SiGe film), films containing metal elements, such as a titanium nitride film (TiN film), a tantalum nitride film (TaN film), a tungsten film (W film), a molybdenum film (Mo film), a ruthenium film (Ru film), a cobalt film (Co film), a nickel film (Ni film), and a copper film (Cu film), an amorphous carbon film (a-C film), a single crystal Si (Si wafer), and the like. Any region (base) may be used as the first surface as long as it is a region (base) where the inhibitor layer may be formed. On the other hand, any region (base) may be used as the second surface as long as it is a region where it is difficult to form the inhibitor layer. These embodiments also obtain the same effects as in the above-described embodiments of the present disclosure.

Further, for example, as the first film and the second film, in addition to the SiN film and the SiCN film, films containing semiconductor elements, such as a SiON film, a SiOCN film, a SiBCN film, a SiBN film, a germanium nitride film (GeN film), and a germanium oxynitride film (GeON film), which are N-containing films, and films containing metal elements, such as a TiN film, a TaN film, a tungsten nitride film (WN film), an aluminum nitride film (AIN film), and a tungsten oxynitride film (WON film), may be formed. When these films are formed, the same effects as in the above-described embodiments are obtained. As long as the second film being higher in oxidation resistance than the first film is formed on the first film, the first film and the second film may be films being different in at least a portion of components from each other, that is, films with different chemical compositions, that is, films made of different materials. In this case, depending on a combination of materials of the first film and the second film, the above-described effects may be further enhanced.

The Recipe used in each process may be provided individually according to the processing contents and may be stored in the memory 121c via a telecommunication line or the external memory 123. Moreover, at the beginning of each process, the CPU 121a may properly select an appropriate recipe from a plurality of recipes stored in the memory 121c according to the processing contents. Thus, it is possible to form films of various types, composition ratios, qualities, and thicknesses with enhanced reproducibility in a single substrate processing apparatus. Further, it is possible to reduce an operator's burden and to quickly start each process while avoiding an operation error.

The recipes mentioned above are not limited to newly-provided ones but may be provided, for example, by modifying existing recipes that are already installed in the substrate processing apparatus. Once the recipes are modified, the modified recipes may be installed in the substrate processing apparatus via a telecommunication line or a recording medium storing the recipes. In addition, the existing recipes already installed in the existing substrate processing apparatus may be directly modified by operating the input/output device 122 of the substrate processing apparatus.

An example in which a film is formed by using a batch-type substrate processing apparatus configured to process a plurality of substrates at a time is described in the above-described embodiments of the present disclosure. The present disclosure is not limited to the above-described embodiments of the present disclosure, but may be suitably applied, for example, to a case where a film is formed by using a single-wafer type substrate processing apparatus configured to process a single substrate or several substrates at a time. In addition, an example in which a film is formed by using a substrate processing apparatus including a hot-wall-type process furnace is described above in the above-described embodiments. The present disclosure is not limited to the above-described embodiments, but may be suitably applied to a case where a film is formed by using a substrate processing apparatus including a cold-wall-type process furnace.

Even in the case of using these substrate processing apparatuses, each process may be performed according to the same processing procedure and processing condition as those in the above-described embodiments and modifications, and the same effects as the above-described embodiments and modifications are achieved.

The above-described embodiments and modifications may be used in proper combination. The processing procedure and processing condition used in this case may be the same as, for example, those in the above-described embodiments and modifications.

[Examples]

<First Example>

An evaluation sample 1 of a first example is provided by performing a processing sequence similar to those of the above-described embodiments on a wafer with a first surface and a second surface similar to those of the above-described embodiments to laminate a SiN film as a first film and a SiN film as a second film (film thickness 0.3 to 0.5 nm) on the second surface. The processing condition in each step when providing the evaluation sample 1 is set to a predetermined condition within a range of the processing condition in each step of the above-described embodiments. In addition, when providing the evaluation sample 1, the chlorosilane-based gas that does not contain the Si-Si bond exemplified in the above-described embodiments is used as a first precursor, the chlorosilane-based gas that contains the Si-Si bond exemplified in the above-described embodiments is used as a second precursor, and the hydrogen nitride-based gas that contains the N-H bond exemplified in the above-described embodiments is used as a first reactant and a second reactant.

<Second Example>

An evaluation sample 2 of a second example is provided by performing a processing sequence similar to those of the above-described embodiments on a wafer including a first surface and a second surface similar to those of the above-described embodiments to laminate a SiN film as a first film and a SiN film as a second film (film thickness 3 to 5 nm) on the second surface. The processing condition in each step when providing the evaluation sample 2 is the same as the processing condition in each step of the first example, except for the number of cycles in a second film-forming step. In addition, when providing the evaluation sample 2, a first precursor, a second precursor, a first reactant, and a second reactant are the same as those when providing the evaluation sample 1.

<Comparative Example>

An evaluation sample 3 of a comparative example is provided by performing each step other than the second film-forming step in the processing sequences of the above-described embodiments on a wafer including a first surface and a second surface similar to those of the above-described embodiments to form a SiN film as a first film on the second surface. The processing condition in each step when providing the evaluation sample 3 is the same as the processing condition in each step of the first example, except for the number of cycles in a first film-forming step. In addition, when providing the evaluation sample 3, a first precursor and a first reactant are the same as those when providing the evaluation sample 1.

<Reference Example>

An evaluation sample 4 of a reference example is provided by performing the second film-forming step in the processing sequences of the above-described embodiments on a wafer to form a SiN film as a second film on the wafer. The processing condition in each step when providing the evaluation sample 4 is the same as the processing condition in each step in the second film-forming step of the first example, except for the number of cycles in the second film-forming step. In addition, when providing the evaluation sample 4, a second precursor and a second reactant are the same as those when providing the evaluation sample 1.

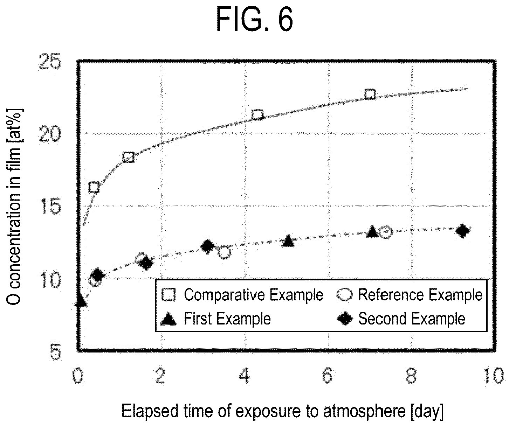

Each of the provided evaluation samples is preserved in the atmosphere, and a change in oxygen (O) concentration in the SiN film (also referred to as a time-dependent change in O concentration) with the elapsed time of exposure to the atmosphere is determined. The O concentration in the SiN film is measured by using the X-ray Photoelectron Spectroscopy (XPS). The results are shown in FIG. 6. In FIG. 6, the horizontal axis indicates the elapsed time (day) of exposure to the atmosphere, and the vertical axis indicates the O concentration (at%) in the SiN film.

As is clear from FIG. 6, it may be seen that the O concentration of each of the evaluation samples 1 and 2 is much lower than the O concentration of the evaluation sample 3. Moreover, it may be seen that an amount of time-dependent change in the O concentration of each of the evaluation samples 1 and 2 is much smaller than an amount of time-dependent change of the O concentration of the evaluation sample 3. In this regard, it is confirmed that the SiN films of the evaluation samples 1 and 2 in the first and second examples being higher in oxidation resistance than the SiN film of the evaluation sample 3 in the comparative example. Moreover, as is clear from FIG. 6, it may be seen that the O concentration of each of the evaluation samples 1 and 2 is equivalent to the O concentration of the evaluation sample 4. Moreover, it may be seen that the amount of time-dependent time in the O concentration of each of the evaluation samples 1 and 2 is equivalent to the amount of time-dependent time in the O concentration of the evaluation sample 4. In this regard, it is confirmed that the SiN films of the evaluation samples 1 and 2 in the first and second examples are as high in oxidation resistance as the SiN film of the evaluation sample 4 in the reference example.

In addition, from these results, it is confirmed that a laminated film (SiN film) of the first film and the second film, which is formed at a relatively high temperature and is equivalent in oxidation resistance to the SiN film of the evaluation sample 4 of the reference example, is formed by performing the processing sequences of the above-described embodiments as in the first and second examples.

According to the present disclosure, it is possible to suppress oxidation of a film, which is formed by selective growth, due to exposure to the atmosphere.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1. A method of processing a substrate, comprising:

   (a) forming an inhibitor layer on a first surface of the substrate, which includes the first surface and a second surface, by supplying a modifying agent that reacts with the first surface to the substrate;
   (b) forming a first film on the second surface by supplying a first film-forming agent, at least a portion of which being provided with a first energy, to the substrate in which the inhibitor layer is formed on the first surface; and
   (c) forming a second film on the first film formed on the second surface by supplying a second film-forming agent, at least a portion of which being provided with a second energy which is higher than the first energy, to the substrate in which the first film is formed on the second surface.

2. The method of Claim 1, wherein in (b), a first precursor and a first reactant are used as the first film-forming agent, and in (c), a second precursor, which is different in molecular structure from the first precursor, and a second reactant are used as the second film-forming agent.

3. The method of Claim 2, wherein a thermal decomposition temperature of the second precursor is lower than a thermal decomposition temperature of the first precursor.

4. The method of Claim 2 or 3, wherein a reactivity of the second precursor is higher than a reactivity of the first precursor under a same condition.

5. The method of any one of Claims 2 to 4, wherein each of the first film and the second film contains atoms X, and wherein the first precursor contains one of the atoms X in one molecule, and the second precursor contains two or more of the atoms X in one molecule.

6. The method of any one of Claims 2 to 5, wherein each of the first film and the second film contains atoms X, and wherein the first precursor contains no chemical bond between the atoms X, and the second precursor contains the chemical bond between the atoms X.

7. The method of any one of Claims 2 to 6, wherein a reactivity between the second precursor and the inhibitor layer is higher than a reactivity between the first precursor and the inhibitor layer.

8. The method of Claim 1, wherein in (b), a first precursor and a first reactant are used as the first film-forming agent, and in (c), a second precursor, a molecular structure of which is the same as a molecular structure of the first precursor, and a second reactant are used as the second film-forming agent.

9. The method of any one of Claims 2 to 8, wherein a molecular structure of the first reactant is the same as a molecular structure of the second reactant.

10. The method of any one of Claims 1 to 9, wherein processing conditions in (b) and (c) are controlled such that a reactivity between the second film-forming agent and the inhibitor layer in (c) is higher than a reactivity between the first film-forming agent and the inhibitor layer in (b).

**11.** The method of any one of Claims 1 to 10, wherein in (b), the first film-forming agent is supplied to the substrate at a first temperature, and in (c), the second film-forming agent is supplied to the substrate at a second temperature higher than the first temperature.

**12.** The method of any one of Claims 1 to 11, wherein in (c), at least one selected from the group of invalidation and removal of at least a portion of the inhibitor layer formed on the first surface is performed in parallel to the formation of the second film on the first film formed on the second surface.

**13.** A method of manufacturing a semiconductor device, comprising:

(a) forming an inhibitor layer on a first surface of a substrate, which includes the first surface and a second surface, by supplying a modifying agent that reacts with the first surface to the substrate;
(b) forming a first film on the second surface by supplying a first film-forming agent, at least a portion of which being provided with a first energy, to the substrate in which the inhibitor layer is formed on the first surface; and
(c) forming a second film on the first film formed on the second surface by supplying a second film-forming agent, at least a portion of which being provided with a second energy which is higher than the first energy, to the substrate in which the first film is formed on the second surface.

**14.** A substrate processing apparatus comprising:

a process chamber (201) in which a substrate is processed;
a modifying agent supply system configured to supply a modifying agent to the substrate in the process chamber (201);
a first film-forming agent supply system configured to supply a first film-forming agent to the substrate in the process chamber (201);
a second film-forming agent supply system configured to supply a second film-forming agent to the substrate in the process chamber (201);
an energy supplier (207) configured to provide an energy to at least a portion of the first film-forming agent and at least a portion of the second film-forming agent; and
a controller (121) configured to be capable of controlling the modifying agent supply system, the first film-forming agent supply system, the second film-forming agent supply system, and the energy supplier (207) to perform a process in the process chamber (201), the process including:

(a) forming an inhibitor layer on a first surface of the substrate, which includes the first surface and a second surface, by supplying the modifying agent that reacts with the first surface to the substrate;
(b) forming a first film on the second surface by supplying the first film-forming agent, at least a portion of which being provided with a first energy, to the substrate in which the inhibitor layer is formed on the first surface; and
(c) forming a second film on the first film formed on the second surface by supplying the second film-forming agent, at least a portion of which being provided with a second energy which is higher than the first energy, to the substrate in which the first film is formed on the second surface.

**15.** A program that causes, by a computer, a substrate processing apparatus to perform:

(a) forming an inhibitor layer on a first surface of the substrate, which includes the first surface and a second surface, by supplying a modifying agent that reacts with the first surface to the substrate;
(b) forming a first film on the second surface by supplying a first film-forming agent, at least a portion of which being provided with a first energy, to the substrate in which the inhibitor layer is formed on the first surface; and
(c) forming a second film on the first film formed on the second surface by supplying a second film-forming agent, at least a portion of which being provided with a second energy which is higher than the first energy, to the substrate in which the first film is formed on the second surface.

# FIG. 1

# FIG. 2

# FIG. 3

# FIG. 4

# FIG. 5A

First surface        Second surface

| First base | Second base |

# FIG. 5B

Inhibitor layer

Second surface

First surface

| Inhibitor layer | |
| First base | Second base |

# FIG. 5C

Inhibitor layer

First surface

Second surface

| Inhibitor layer | First film |
| First base | Second base |

# FIG. 5D

Second film

Second film

First surface

Second surface

| | Second film |
| Second film | First film |
| First base | Second base |

# FIG. 6

Y-axis: O concentration in film [at%]

X-axis: Elapsed time of exposure to atmosphere [day]

Legend:
- □ Comparative Example
- ○ Reference Example
- ▲ First Example
- ◆ Second Example

Europäisches
Patentamt

European
Patent Office

Office européen
des brevets

# EUROPEAN SEARCH REPORT

**Application Number**

EP 23 15 6372

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/080782 A1 (IPS LTD [KR]; KIM SOO-HYUN [KR] ET AL.) 3 August 2006 (2006-08-03) * paragraph [0024]; figure 2 * * paragraph [0026]; figure 2 * * paragraph [0030] * * paragraph [0058] – paragraph [0066]; figure 5 * | 14,15 | INV. C23C16/04 C23C16/455 C23C16/34 |
| A | US 2021/366706 A1 (NAKATANI KIMIHIKO [JP]) 25 November 2021 (2021-11-25) * paragraph [0060] * * paragraph [0067] * * paragraph [0074] * * paragraph [0081] – paragraph [0092] * * paragraph [0093] – paragraph [0101] * * paragraph [0103] * * paragraph [0111] * | 1-15 | |
| A | US 2021/035801 A1 (WASEDA TAKAYUKI [JP] ET AL) 4 February 2021 (2021-02-04) * column 9, line 41 – column 10, line 62 * * column 11, line 18 – column 13, line 8 * * column 15, line 10 – column 17, line 47 * | 1-15 | TECHNICAL FIELDS SEARCHED (IPC) C23C |
| A | US 2021/246547 A1 (AZUMO SHUJI [JP] ET AL) 12 August 2021 (2021-08-12) * paragraph [0129] * | 1-15 | |
| A | US 2019/157079 A1 (KE CHANG [US] ET AL) 23 May 2019 (2019-05-23) * paragraph [0062] * | 1-15 | |
| A | US 2020/048762 A1 (KE CHANG [US] ET AL) 13 February 2020 (2020-02-13) * paragraph [0038] * | 1-15 | |

The present search report has been drawn up for all claims

| Place of search | Date of completion of the search | Examiner |
|---|---|---|
| The Hague | 14 August 2023 | Kudelka, Stephan |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

........................................................................

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 23 15 6372

This annex lists the patent family members relating to the patent documents cited in the above-mentioned European search report.
The members are as contained in the European Patent Office EDP file on
The European Patent Office is in no way liable for these particulars which are merely given for the purpose of information.

14-08-2023

| Patent document cited in search report | | | Publication date | Patent family member(s) | | | Publication date |
|---|---|---|---|---|---|---|---|
| WO 2006080782 | A1 | | 03-08-2006 | KR | 20060086241 | A | 31-07-2006 |
| | | | | TW | I319442 | B | 11-01-2010 |
| | | | | WO | 2006080782 | A1 | 03-08-2006 |
| US 2021366706 | A1 | | 25-11-2021 | CN | 111710604 | A | 25-09-2020 |
| | | | | CN | 116435177 | A | 14-07-2023 |
| | | | | JP | 6860605 | B2 | 14-04-2021 |
| | | | | JP | 7050985 | B2 | 08-04-2022 |
| | | | | JP | 2020155452 | A | 24-09-2020 |
| | | | | JP | 2021101486 | A | 08-07-2021 |
| | | | | KR | 20200111103 | A | 28-09-2020 |
| | | | | KR | 20220032034 | A | 15-03-2022 |
| | | | | KR | 20220113328 | A | 12-08-2022 |
| | | | | TW | 202035762 | A | 01-10-2020 |
| | | | | TW | 202200823 | A | 01-01-2022 |
| | | | | US | 2020303186 | A1 | 24-09-2020 |
| | | | | US | 2021366706 | A1 | 25-11-2021 |
| US 2021035801 | A1 | | 04-02-2021 | CN | 112309830 | A | 02-02-2021 |
| | | | | JP | 6953480 | B2 | 27-10-2021 |
| | | | | JP | 2021027067 | A | 22-02-2021 |
| | | | | KR | 20210015679 | A | 10-02-2021 |
| | | | | SG | 10202007309T | A | 25-02-2021 |
| | | | | TW | 202111780 | A | 16-03-2021 |
| | | | | US | 2021035801 | A1 | 04-02-2021 |
| | | | | US | 2022277955 | A1 | 01-09-2022 |
| US 2021246547 | A1 | | 12-08-2021 | JP | 2021125607 | A | 30-08-2021 |
| | | | | KR | 20210100532 | A | 17-08-2021 |
| | | | | US | 2021246547 | A1 | 12-08-2021 |
| US 2019157079 | A1 | | 23-05-2019 | US | 2019157079 | A1 | 23-05-2019 |
| | | | | US | 2021217615 | A1 | 15-07-2021 |
| US 2020048762 | A1 | | 13-02-2020 | CN | 112567498 | A | 26-03-2021 |
| | | | | JP | 7189321 | B2 | 13-12-2022 |
| | | | | JP | 2021533272 | A | 02-12-2021 |
| | | | | KR | 20210031530 | A | 19-03-2021 |
| | | | | TW | 202009318 | A | 01-03-2020 |
| | | | | US | 2020048762 | A1 | 13-02-2020 |
| | | | | WO | 2020033698 | A1 | 13-02-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2022039581 A